# EUROPEAN PATENT APPLICATION

(11) **EP 1 248 150 A2**
(43) Date of publication of application: **09.10.2002**
(21) Application number: 02008746.6
(22) Date of filing: 28.12.1994
(51) Int. Cl.: G03F 7/039, G03F 7/004, C08L 33/06, C08L 33/20, C08L 25/18, H05K 3/06

(54) **Radiation sensitive material and method for forming pattern**

(30) Priority: 28.12.1993 JP 33743493
(62) Divisional of application: 94309847.5
(71) Applicant: FUJITSU LIMITED, Kawasaki-shi, Kanagawa 211-8588 (JP)
(72) Inventor: Takechi, Satoshi, Kawasaki-shi, Kanagawa 211-8588 (JP); Takahashi, Makoto, Kawasaki-shi, Kanagawa 211-8588 (JP); Kaimoto, Yuko, Kawasaki-shi, Kanagawa 211-8588 (JP)
(74) Representative: Silverman, Warren

(57) **Abstract**

Groups of radiation sensitive materials including various (meth) acrylic acid / (meth) acrylic ester monomer-based copolymers either used with compounds generating acids on application of radiation or containing hydrophilic groups and used with hydrophobic compounds and which monomers may alternatively be itaconic acid derivatives with certain specified substituting groups, are used in production of photoresists which are selectively exposed between prebaking and postbaking steps, after which the resists are developed to form the desired pattern. Preferably, the baked resists contain adamantyl substituents.

## Description

### BACKGROUND OF THE INVENTION

The present invention relates to a radiation sensitive material and a process for forming a pattern using the same.

Recently, semiconductor integrated circuits have become more integrated and LSls and VLSIs are practically available. Accompanying such integration, circuit patterns have become smaller in size, approaching submicron dimensions and even smaller. Formation of a pattern in a submicron dimension essentially requires lithography. In lithography a thin film resist is deposited on to a substrate to be processed, and is selectively exposed and developed to form a resist pattern. With this resist pattern as a mask, dry etching is conducted and then the resist is removed to obtain a required pattern. As an exposure source for lithography, ultraviolet radiation was originally used, but as circuit patterns approach submicron sizes, far ultraviolet radiation (e.g. electron beams, X rays, etc.) with short wavelengths, are used as exposure sources.

Especially for lithography using excimer lasers (248-nm wavelength KrF laser and 193-nm wavelength ArF laser), resist materials having high resolution, high sensitivity and good dry-etching resistance are required.

Many conventionally developed resists are based on phenol resin and novolak resin. These materials have aromatic rings and good dry etching resistance, but they have poor transparency at KrF wavelength and are totally opaque at ArF wavelength. Consequently they can not provide patterns sufficiently precise in submicron dimensions.

On the other hand, as a transparent resist for excimer beams, t-butyl methacrylate polymer is proposed, but this resist lacks dry etching resistance.

As a countermeasure to this, the inventors have proposed a chemical amplification type resist using alicyclic groups as a resist having dry etching resistance comparable with that of aromatic compounds and are transparent at KrF and ArF wavelength. Here alicyclic groups are adamantane, norbornane, perhydroantracene, cyclohexane, tricyclo [5.2.1.0^{2.6}] decane etc., and adamantyl groups are suitable (see Japanese Patent Laid-Open Publication No. 39665/1992).

But the chemical amplification type resist of alicyclic copolymer increases hydrophobicity and rigidity of the alicyclic group, which gives dry etching resistance, increases its composition ratio.

At a composition ratio which gives dry etching resistance comparable to that of phenol resin-based and novolak resin-based resists, e.g., above 50 mol% of alicyclic unit, because of high hydrophobicity and rigidity of the resists, diffusion of protonic acid as a catalyst is hindered, which results in lower amplification, smaller amounts of carboxylic acid being generated, and lower solubility to a developer of an alkaline aqueous solution.

Furthermore, these resists lack adhesiveness, and, in addition, their resist films are rigid because of inclusion of alicyclic groups. As a result, strain caused to the resist films become larger, and the resist films have a greater tendency to peel off. Accordingly stable pattern characteristics cannot be obtained. This is also a problem.

### SUMMARY OF THE INVENTION

In view of these problems, an object of the present invention is to provide a radiation sensitive material for an excimer laser lithography, having good transparency and etching resistance, is highly sensitive, has good adhesion and to provide a method for forming a circuit pattern using the radiation sensitive material.

Another object of the present invention is to provide a method for forming a pattern which can produce a protective film from even a non-phenol based polymer of low polarity, and which can have stable pattern characteristics.

The above-described object of the present invention is achieved by a radiation sensitive material comprising a terpolymer expressed by a general formula 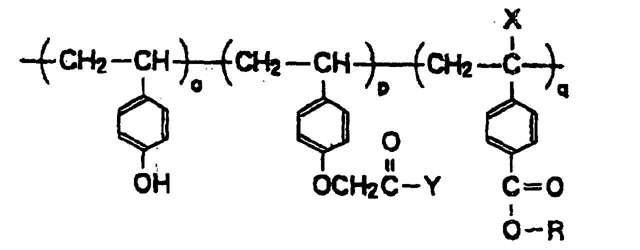
(where X represents H or CH₃; 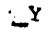 is an alicyclic group;
R represents 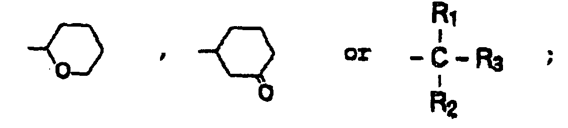 and
R₁ and R₂ represent H, R₃ represents 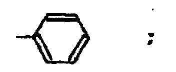 or
R₁ represents CH₃, R₂ represents H, R₃ represents 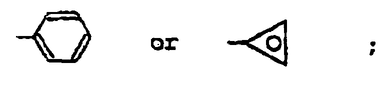 or
R₁ and R₂ represent CH₃, R₃ represents 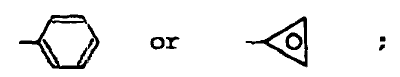 or
R₁ , R₂ and R₃ all represent CH₃); and a substance generating an acid by application of radiation.

The above-described object is achieved by a radiation sensitive material comprising a resist containing a hydrophilic group and a hydrophobic compound.

It is preferred that the resist containing a hydrophilic group is a copolymer expressed by a general formula 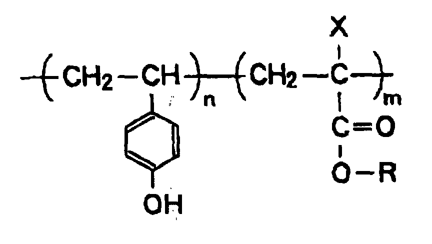
(where X represents H or CH₃;
R represents 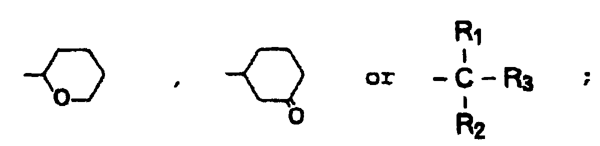 and
R₁ and R₂ represent H, R₃ represents 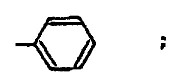
R₁ represents CH₃, R₂ represents H, R₃ represents 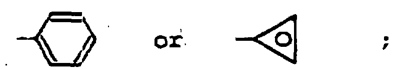
R₁ and R₂ represent CH₃, R₃ represents 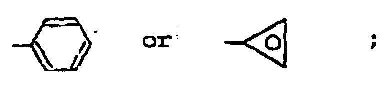 or
R₁ , R₂ and R₃ represent CH₃)

In the above-described radiation sensitive material, the resist contains vinylphenol, which contains hydrophilic groups, in the range of 50 - 70 mol%.

In the above-described radiation sensitive material, the resist containing hydrophilic groups is a copolymer expressed by a general formula

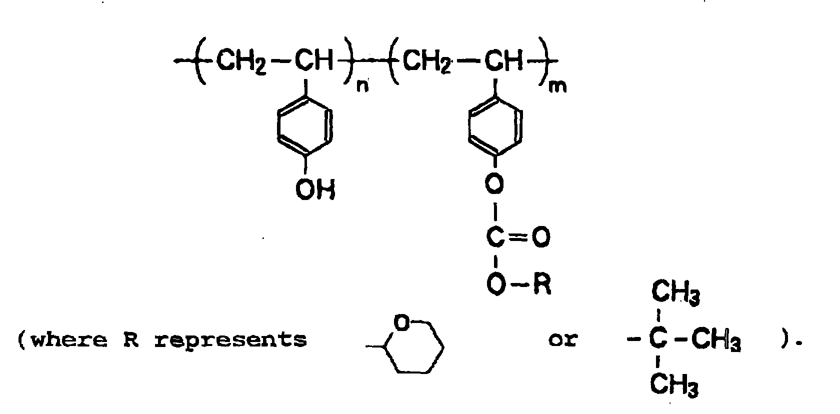

In the above-described radiation sensitive material, it is preferred that the resist contains vinylphenol, which contains hydrophilic groups, in the range of 60 - 80 mol%.

In the above-described radiation sensitive material, it is preferred that the hydrophobic compound is expressed by a general formula

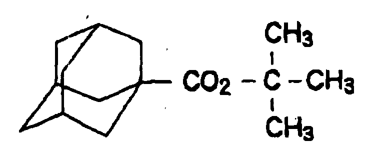

In the above-described radiation sensitive material, it is preferred that the hydrophobic compound is expressed by a general formula 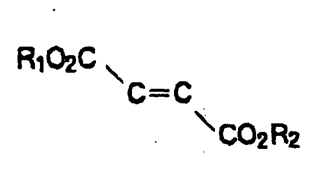 (where R₁ and R₂ represent 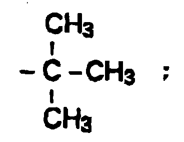 or
R₁ represents 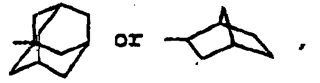 R₂ represents

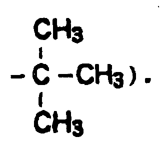

The above-described object of the present invention is achieved by a radiation sensitive material comprising polymer units derived from itaconic anhydride and expressed by 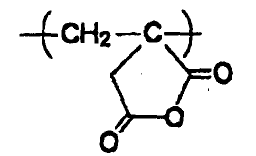 and polymer units which generates a alkali soluble group in the presence of an acid; and a substance generating an acid, upon application of radiation.

In the above-described radiation sensitive material, it is preferred that the copolymer is expressed by a general formula. 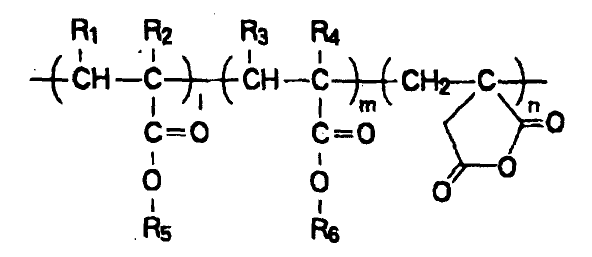 (where l, m and n represent 0 - 60 mol%, 10 - 95 mol%, 5 - 50 mol% respectively; R₁, R₂, R₃ and R₄ represent H, halogen, C₁₋₄ alkyl group, C₁₋₄ substituted alkyl group, nitrile group, -(CH₂)ₙCOOR₅(n=0-1) or -(CH₂)ₙCOOR₆(n=0-1); R₅ represents C₁₋₅ alkyl group, C₁₋₅ substituted alkyl group, alicyclic group, substituted alicyclic group, aromatic group or substituted aromatic group; and R₆ represents t-butyl group, t-amyl group, dimethylbenzyl group, tetrahydropyranyl group or 3-oxocyclohexyl group).

In the above-described radiation sensitive material, it is preferred that the copolymer is expressed by 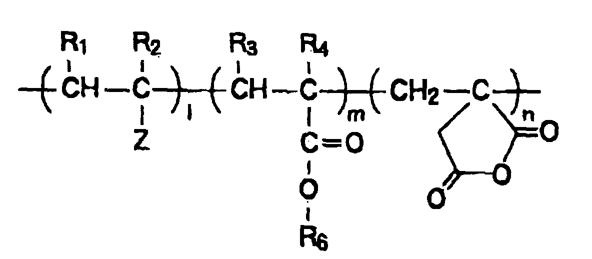 (where l, m and n represent 1 - 95 mol%, 10 - 95 mol% and 5 - 50 mol%; Z represents benzene ring, substituted benzene ring, nitrile group, -OR₇, -COR₇ or -OCOR₇; R₁, R₂, R₃ and R₄ represent H, halogen, C₁₋₄ alkyl group, C₁₋₄ substituted alkyl group, nitrile group, -C(CH₂)ₙCOOR₅(n=0-1), or -(CH₂)ₙCOOR₆(n=0-1); R₆ represents t-butyl group, t-amyl group, dimethylbenzyl group, tetrahydropyranyl group or 3-oxocyclohexyl group; R₇ represents C₁₋₅ alkyl group, C₁₋₅ substituted alkyl group, alicyclic group, substituted alicyclic group, aromatic group or substituted aromatic group).

In the above-described radiation sensitive material, it is preferred that the copolymer is expressed by a general formula 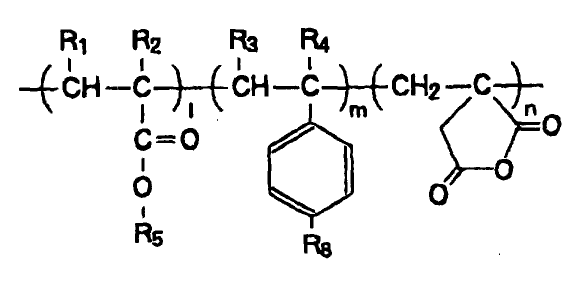 (where l, m and n represent 0 - 95 mol%, 1 - 95 mol% and 5 - 50 mol%; R₁, R₂, R₃ and R₄ represent H, halogen, C₁₋₄ alkyl group, C₁₋₄ substituted alkyl group, nitrile group, -(CH₂)ₙCOOR₅(n=0-1) or -(CH₂)ₙCOOR₆(n=0-1); R₅ represents C₁₋₅ alkyl group, C₁₋₅ substituted alkyl group, alicyclic group, substituted alicyclic group, aromatic group or substituted aromatic group; and R₈ represents -OtBu, -OCOOtBu or -COOt-Amyl).

In the above-described radiation sensitive material, the copolymer is expressed by a general formula 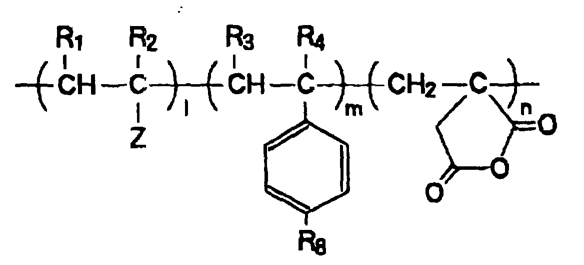 (where l, m and n represent 0 - 95 mol%, 1 - 95 mol% and 5 - 50 mol%; Z represents benzene ring, substituted benzene ring, nitrile group, OR₇, -COR₇ or -OCOR₇; R₁, R₂, R₃ and R₄ represent H, halogen, C₁₋₄ alkyl group, C₁₋₄ substituted alkyl group, nitrile group, -(CH₂)ₙCOOR₅(n=0-1) or -(CH₂)ₙCOOR₆(n=0-1); and R₈ represents -OtBu, -OCOOtBu, or -COOt-Amyl).

In the above-described radiation sensitive material, it is preferred that the copolymer includes the unit structure including itaconic anhydride by 5 - 50 mol%.

The above-described object of the present invention is achieved by a method for forming a pattern comprising the steps of: preparing a resist of the above-described radiation sensitive material; applying the resist to a substrate to be processed; prebaking the resist film and then selectively exposing the resist on the substrate to radiation; and post exposure baking and then developing the resist on the substrate to form the pattern.

The above-described object of the present invention is achieved by a method for forming a pattern comprising the steps of: preparing a resist of a radiation sensitive material; applying the resist to a substrate to be processed; prebaking the resist film and then selectively exposing the resist on the substrate to radiation; and post exposure baking the substrate and then developing the resist on the substrate by a developer being a mixed liquid of an organic alkaline aqueous solution and isopropyl alcohol to form the pattern.

Here the radiation sensitive material preferably comprises: a copolymer including a unit structure including alicyclic groups, e.g., adamantyl groups, norbornyl group, and a unit structure generating an alkali soluble group in the presence of an acid; and a substance generating an acid by application of radiation.

In the above-described radiation sensitive material, it is preferable that the developer contains isopropyl alcohol by 5 - 95 vol%.

The above-described object is achieved by a method for forming a pattern comprising the steps of: preparing a resist of a polymer containing an acrylic or methacrylic ester unit, having an alicyclic group at said acrylic or methacrylic ester unit; where said acrylic or methacrylic ester unit have a polar structure at an ester unit; coating a substrate to be processed with the resist, and prebaking the substrate to be processed; applying onto the resist a protecting film of a hydrocarbon-based polymer, which is transparent to far ultraviolet rays, and heating the same; selectively exposing radiation to the resist on the substrate to be processed; postbaking the substrate to be processed; stripping the protecting film; and developing the resist on the substrate to be processed to form a desired resist pattern, an application solvent for the hydrocarbon-based polymer of the protecting film being a non-aromatic hydrocarbon, or an aromatic hydrocarbon expressed by a general formula 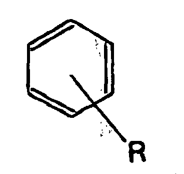 (where R represents an alkyl group with 3 or more carbon atoms).

The above-described object of the present invention is achieved by a method for forming a pattern comprising the steps of forming a resist of a radiation sensitive material according to any one of claims 7 to 12; coating a substrate-to-be processed with the resist, and prebaking the substrate to be processed; applying a protecting film of a hydrocarbon polymer, which is transparent to far ultraviolet rays, and heating the same; selectively exposing radiation to the resist on the substrate to be processed, and postbaking the substrate to be processed; and stripping the protecting film, and developing the resist on the substrate to be processed to form a desired resist pattern.

In the above-described method for forming a pattern, it is preferred that an application solvent for the hydrocarbon polymer for the protecting film is limonene, 1,5-cyclooctadiene, 1-decene, t-butylcyclohexane, p-cymene or dodecylbenzene.

In the method for forming a pattern, it is preferred that the hydrocarbon polymer is an olefine polymer or a diene polymer.

In the above-described method, the substance having a polar-structure is ketone, alcohol, ether, ester, carbonic acid, an acid anhydride or any one of these substances having a part of the atoms of a polar structure.

A substance generating an acid by application of radiation used in the above-described radiation sensitive material, i.e., an acid generating substance can be provided by:
a s-triazine derivative expressed by the general formula 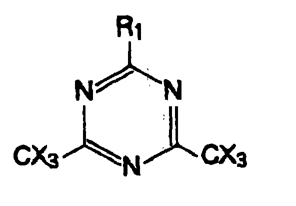 (where R₁ represents a substituted or an unsubstituted aryl group or alkenyl group; and X represents Cl or Br),
an oxazole derivative expressed by the general formula 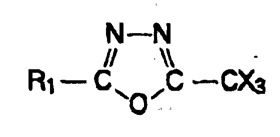 (where R₁ represents CH₃, a substituted or an unsubstituted alkyl group, or a substituted or an unsubstituted aryl or alkenyl group; and X represents Cl or Br),
an iodonium salt expressed by the general formula 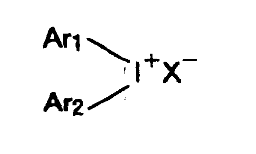 (where Ar₁ and Ar₂ represent a substituted or an unsubstituted aromatic ring; and X represents BF₆⁻, PF₆⁻, AsF₆⁻, SbF₆⁻ or ClO₄⁻, or an organic sulfonic acid anion),
a sulfonium salt expressed by the general formula 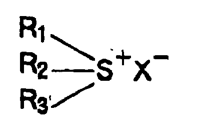 (where R₁, R₂ and R₃ represent a substituted or unsubstituted alkyl group, or an aromatic ring; X represents BF₆⁻, PF₆⁻, AsF₆⁻, SbF₆⁻ or ClO₄⁻, or an organic sulfonic acid anion),
a disulfone derivative expressed by the general formula

   R₁―SO₂―SO₂―R₂

   (where R₁ and R₂ represent a substituted aromatic ring or an alicyclic group),
an imidosulfonate derivative expressed by the general formula 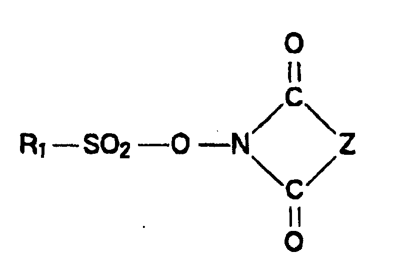 (where R₁ represents a substituted or unsubstituted alkyl group or aryl group; and Z represents a substituted or unsubstituted alkylene group, alkeneylene group or aryl group), or
a diazonium salt expressed by the general formula

   Ar₁―N₂⁺Y⁻

   (where Ar₁ represents a substituted or an unsubstituted aromatic ring; Y represents BF₆⁻, PF₆⁻, AsF₆⁻, SbF₆⁻ or ClO₄⁻, or an organic sulfonic acid anion). But the acid generating substance is not limited to the above-described substances.

A radiation sensitive material comprising a polymer expressed by a general formula 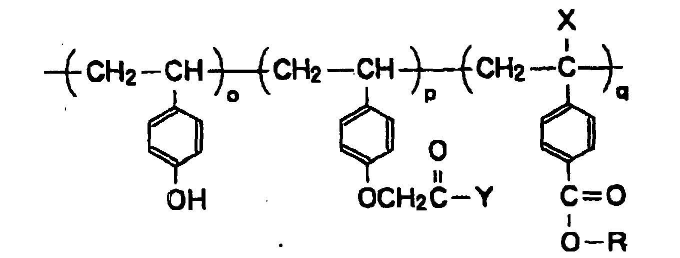 (where X represents H or CH₃; Y is an alicyclic group:
R represents 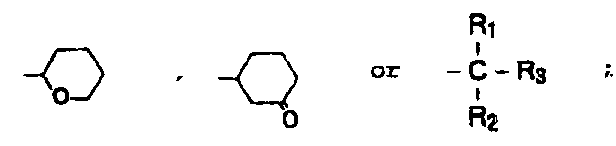 and
R₁ and R₂ represent H, R₃ represents 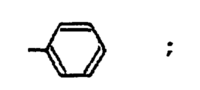 R₁ represents CH₃, R₂ represents H, R₃ represents 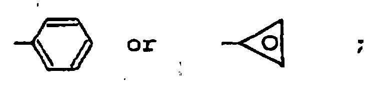 or
R₁ and R₂ represent CH₃, R₃ represents 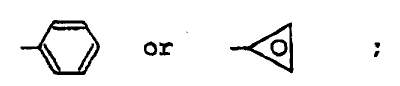 or
R₁, R₂ and R₃ represents CH₃); containing hydrophilic groups and highly hydrophobic groups (e.g., adamantyl, norbornyl, cyclohexyl); and a substance generating an acid by application of radiation; and a radiation sensitive material comprising a copolymer which is expressed by a general formula 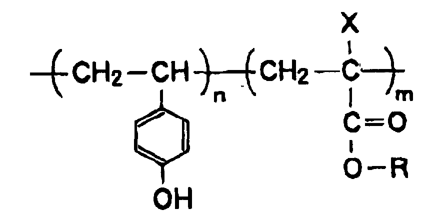
(where X represents H or CH₃;
R represents 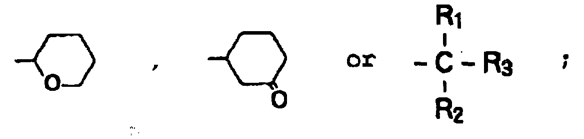 and
R₁ and R₂ represent H, R₃ represents 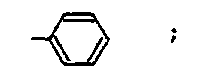
R₁ represents CH₃, R₂ represents H, R₃ represents 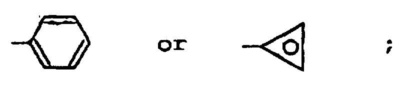 or
R₁ and R₂ represent CH₃, R₃ represents 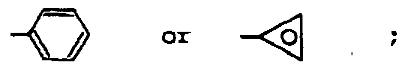 or
R₁, R₂ and R₃ represents CH₃); or a copolymer containing hydrophilic groups and expressed by a general formula 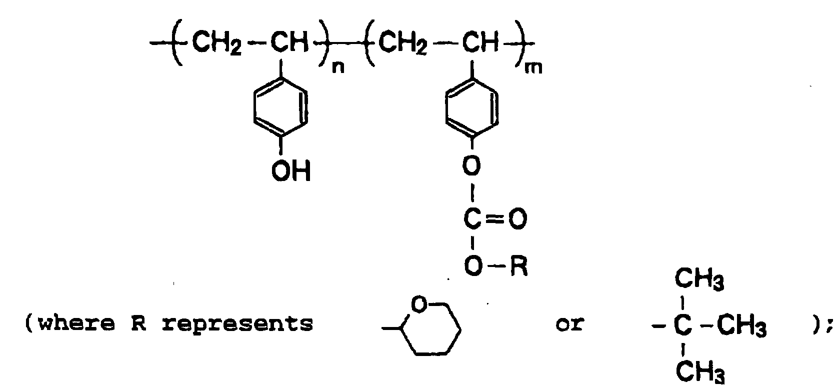 and
a highly hydrophobic compound expressed by a general formula 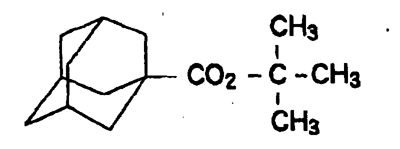 or by a general formula 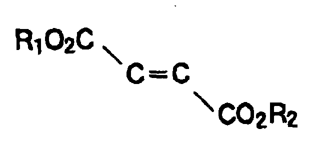 (where R₁ and R₂ represent 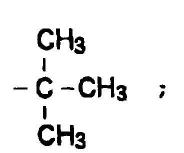 or
R₁ represents 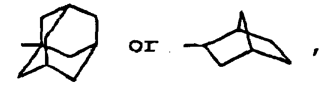 R₂ represents 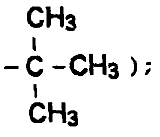 are inhibited by the highly hydrophobic groups from deactivation due to contaminants (amine, etc.) in environments from the exposure to the baking, and can have high sensitivity simply by changing photosensitive groups to a small amount of alkali soluble hydrophilic groups, so that resists especially those containing highly hydrophobic groups can be stably patterned.

Here, when the hydrophilic group-content copolymer contains an excessive ratio of vinylphenol expressed by the structural formula 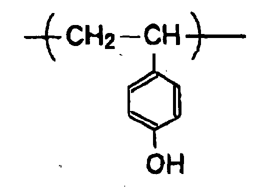 the copolymer is soluble in a developer, so that even unexposed parts are solved, and patterns cannot be formed. When the vinylphenol is contained by a too small ratio, resists cannot be well stripped so that stable patterning cannot be conducted. Thus it is preferred that the hydrophilic group-content copolymer expressed by a structural formula 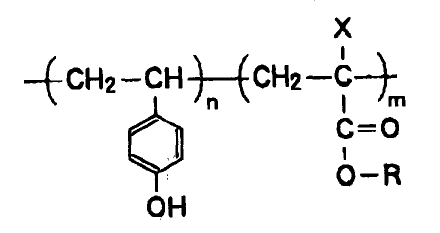 (where
X represents H or CH₃;
R represents 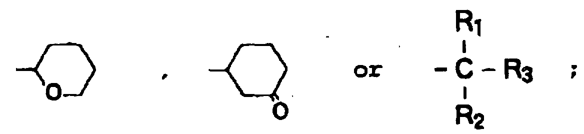 and
R₁ and R₂ represent H, R₃ represents 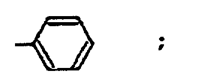
R₁ represents CH₃, R₂ represents H, R₃ represents 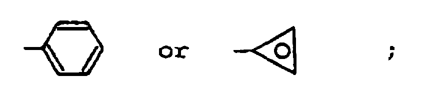
R₁ and R₂ represent CH₃, R₃ represents 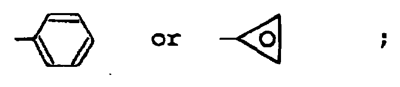 or
R₁ , R₂ and R₃ represent CH₃); contains vinylphenol by 50 - 70 mol%. It is preferred that the hydrophilic group-content copolymer expressed by the structural formula 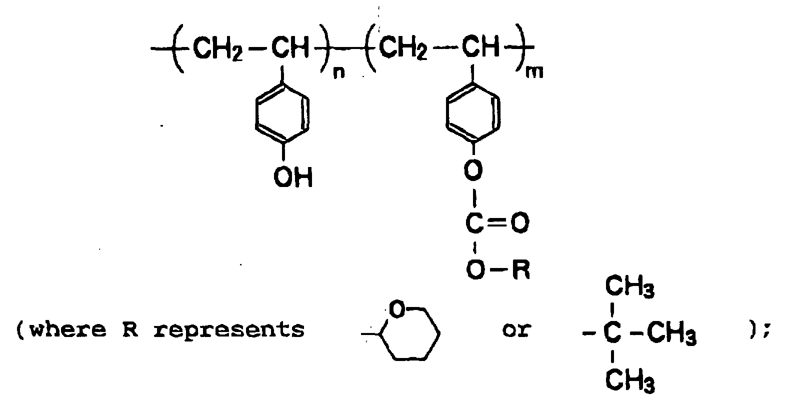 contains vinylphenol by 60 - 80 mol%.

By use of the radiation sensitive material comprising a copolymer including itaconic anhydride which is expressed by 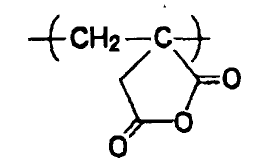 and a polymer as a unit structure which generates an alkali soluble group in the presence of an acid, and by use of a substance generating an acid by application of radiation, resists which have good adhesion can be formed. That is, because of the strong polarity of itaconic anhydride, adhesion of resists to substrates can be greatly improved.

Itaconic anhydride itself exhibits solubility to alkali, and has to be fed to use itaconic anhydride without impairing patterning characteristics. A feed amount of itaconic anhydride is preferably 5 - 50 mol% although this depends on compositions and structures of the polymer. With a feed amount of 5 mol% exclusive of 5 mol%, the adhesion cannot be improved. With a feed amount exceeding 50 mol%, the resist itself becomes alkali soluble, the unexposed part of the resist is also resolved, and patterning is impossible.

Feed of such alkali soluble groups is very effective to improve resolubility of the pattern, and good patterning characteristics can be obtained.

The copolymer containing itaconic anhydride has specific structures expressed by the general formula 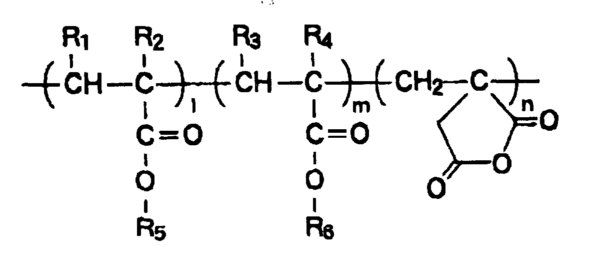 (where l, m and n represent 0 - 60 mol%, 10 - 95 mol%, 5 - 50 mol% respectively; R₁, R₂, R₃ and R₄ represent H, halogen, C₁₋₄ alkyl group, C₁₋₄ substituted alkyl group, nitrile group, -(CH₂)ₙCOOR₅(n=0-1) or -(CH₂)ₙCOOR₆(n=0-1); R₅ represents C₁₋₅ alkyl group, C₁₋₅ substituted alkyl group, alicyclic group, substituted alicyclic group, aromatic group or substituted aromatic group; and R₆ represents t-butyl group, t-amyl group, dimethylbenzyl group, tetrahydropyranyl group or 3-oxocyclohexyl group), 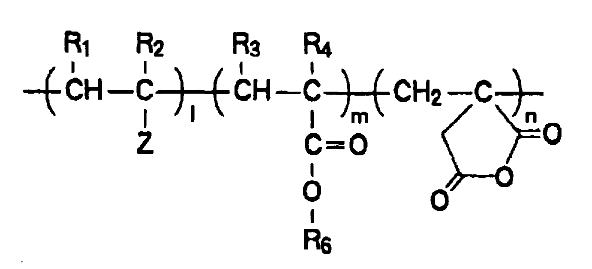 (where l, m and n represent 1 - 95 mol%, 10 - 95 mol% and 5 - 50 mol%; Z represents benzene ring, substituted benzene ring, nitrile group, -OR₇, -COR₇ or -OCOR₇; R₁, R₂, R₃ and R₄ represent H, halogen, C₁₋₄ alkyl group, C₁₋₄ substituted alkyl group, nitrile group, -C(CH₂)ₙCOOR₅(n=0-1), or -(CH₂)ₙCOOR₆(n=0-1); R₆ represents t-butyl group, t-amyl group, dimethylbenzyl group, tetrahydropyranyl group or 3-oxocyclohexyl group; R₇ represents a C₁₋₅ alkyl group, C₁₋₅ substituted alkyl group, alicyclic group, substituted alicyclic group, aromatic group or substituted aromatic group), 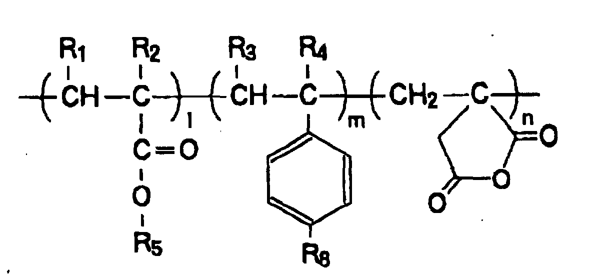 (where l, m and n represent 0 - 95 mol%, 1 - 95 mol% and 5 - 50 mol%; Z represents benzene ring, substituted benzene ring, nitrile group, OR₇, -COR₇ or -OCOR₇; R₁, R₂, R₃ and R₄ represent H, halogen, C₁₋₄ alkyl group, C₁₋₄ substituted alkyl group, nitrile group, -(CH₂)ₙCOOR₅(n=0-1) or -(CH₂)ₙCOOR₆(n=0-1); and R₈ represents -OtBu, -OCOOtBu, or -COOt-Amyl), 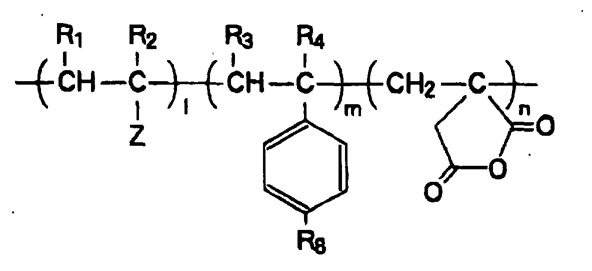 (where l, m and n represent 0 - 95 mol%, 1 - 95 mol% and 5 - 50 mol%; Z represents benzene ring, substituted benzene ring, nitrile group, OR₇, -COR₇ or -OCOR₇; R₁, R₂, R₃ and R₄ represent H, halogen, C₁₋₄ alkyl group, C₁₋₄ substituted alkyl group, nitrile group, -(CH₂)ₙCOOR₅(n=0-1) or -(CH₂)ₙCOOR₆(n=0-1); and R₈ represents -OtBu, -OCOOtBu, or -COOt-Amyl), or other structures.

Here the so-called alicyclic group is adamantyl, norbornyl, cyclohexyl, a substance partially having tricyclo[5.2.1.0] decane skeleton or others, but is not limited to them.

Groups generating alkali soluble groups in the presence of an acid are t-butyl ester, t-amyl ester, t-butyl ether, t-BOC, tetrahydropyranyl, tetrahydropyranyl ether, 3-oxocyclohexyl ester or dimethylbenzyl ester, but is not limited to them.

That is, a resist is formed of the above-described radiation sensitive material, and the resist is applied onto a substrate to be processed, prebaked, exposed, postbaked and developed, and is subjected to other treatments, whereby a submicron dimension pattern can be formed stably.

To obtain more stable patterning characteristics, it is necessary to improve developers. Chemical amplifying resists have the intrinsic problem that protonic acid becomes inactive on the surface layers due to contamination by environmental amine, etc. Consequently solubility differences take place between the surface and inner layers, which is a serious factor that hinders stable patterning. Especially adamantyl groups, t-butyl groups, etc., Hydrocarbons, which are very hydrophobic, especially adamantyl groups, t-butyl groups, etc., are effective to hinder dissolution in developers, and are very effective at making the surface insoluble.

Accordingly, a mixed liquid of an organic alkaline aqueous solution and isopropyl alcohol preferably used as developer, whereby solubility is much improved and smaller solubility differences between the surface and inner layers can be obtained, so allowing stable patterning. Isopropyl alcohol is the most effective alcohol to be added as methanol and ethanol cause cracks, and peelings are found. The use of this liquid mixture developer raised the sensitivity by one or more places and reduced strain caused upon development, so that the adhesiveness was much improved.

It is preferable that the developer contains isopropyl alcohol by 5 - 95 vol%. This is because content of isopropyl alcohol by below 5 mol% does not improve the sensitivity, and content above 95 mol% easily causes cracks and crazes.

A polymer containing an acrylic or methacrylic ester unit, each having an alicyclic group and a polar structure at an ester unit, has such a high base polymer polarity that the very high hydrophobicity due to the alicyclic group can be lowered. As a result, polarity differences occur between the polymer and the hydrocarbon-based protecting film, and the protecting film can be applied without resolving the resist film, whereby a pattern of a desired size can be formed.

Examples of substances having high polarity structures are ketone, alcohol, ether, ester, carbonic acid, an acid anhydride, or any one of these substances having some of the atoms of their polar structure replaced by sulfur, nitrogen or halogen atoms, but is not limited to them.

The ratio of feed of the materials having polar structures must be at least 1 - 50 mol%, preferably 20% or greater.

Although the resist containing itaconic anhydride contains highly hydrophobic hydrocarbon groups, the resist permits hydrocarbon-based polymers, which have not been conventionally applied to the resist as a protecting film because of the high polarity of itaconic anhydride.

Formation of such protecting films on the resist can avoid the problem of PED (Post Exposure Delay), which is characteristic of chemical width increment resists.

A high molecular weight hydrocarbon-based solvent is used as the solvent for application of the protecting film, so that the protecting film can be applied with higher accuracy. Application solvents with too low a boiling point make it difficult to uniformly apply the protecting film on wafers. Preferably solvents have boiling points above 100°C are used. Examples of preferable solvents are limonene, 1,5-cyclooctadiene, 1-decene, t-butylcyclohexane, p-cymene, dodecylbenzene, etc.

The hydrocarbon polymer is, for example, olefine, diene, etc. but is not limited to them as long as the hydrocarbon polymers are transparent to exposure wavelengths and are soluble in the above-mentioned solvent.

The alicyclic group is, for example, cyclohexane, norbornane, adamantyl, and substances having a tricyclo [5.2.1.0] decane skeleton, but is not limited to them.

### BRIEF DESCRIPTION OF THE DRAWINGS

FIG. 1 is the flow chart of one example of the semiconductor fabrication method according to the present invention;
FIGs. 2A to 2G are sectional views of a semiconductor device in the steps of one example of the semiconductor fabrication method according to the present invention;
FIG. 3 is the flow chart of another example of the semiconductor fabrication method according to the present invention;
FIGs. 4A to 4H are sectional views of a semiconductor device in the steps of another example of the semiconductor fabrication method according to the present invention.

### DETAILED DESCRIPTION OF THE PREFERRED EMBODIMENTS

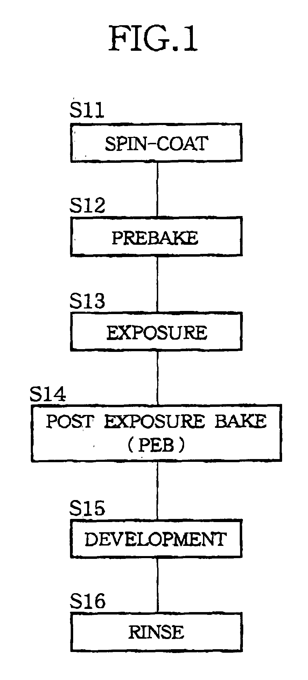

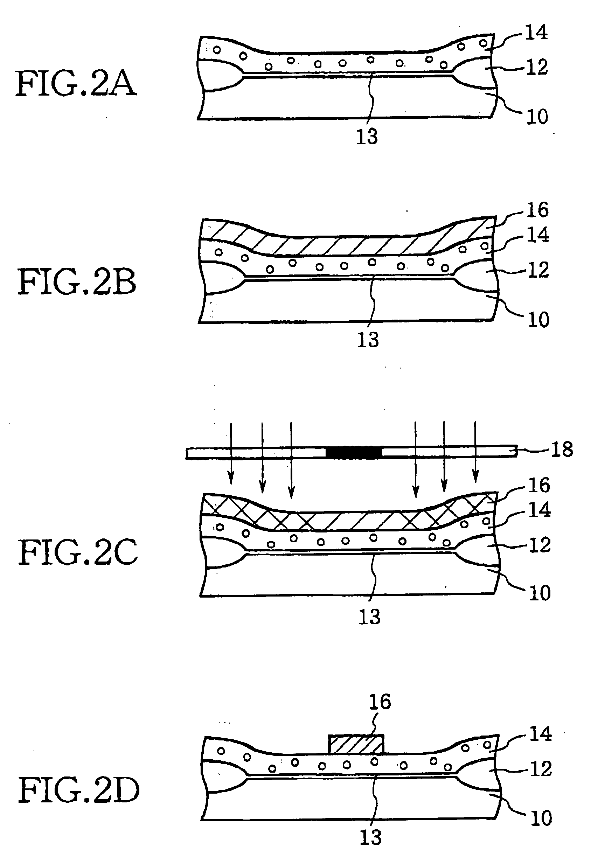

An example of the semiconductor fabrication method according to the present invention will be explained with reference to FIGs. 1, and 2A to 2G.

In patterning a polycrystalline silicon film 14 deposited through an oxide film 13 on a semiconductor substrate 10 with a field isolation 12 formed on as shown in FIG. 2A, a resist film 16 is applied to the semiconductor substrate 10 with a polycrystalline silicon film 14 formed on (Step S11), and prebaked (Step S12) (FIG. 2B).

Then, the semiconductor substrate 10 with the resist film 16 deposited on is exposed through a mask 18 for selective exposure (Step S13, FIG. 2C).

Following postbake (Step S14), the resist film 16 is developed with a developer (Step S15) and patterned. Subsequently the semiconductor substrate 10 is rinsed with deionized water (Step S16). Thus the patterned resist film 16 is formed on the semiconductor substrate 10 (FIG. 2D).

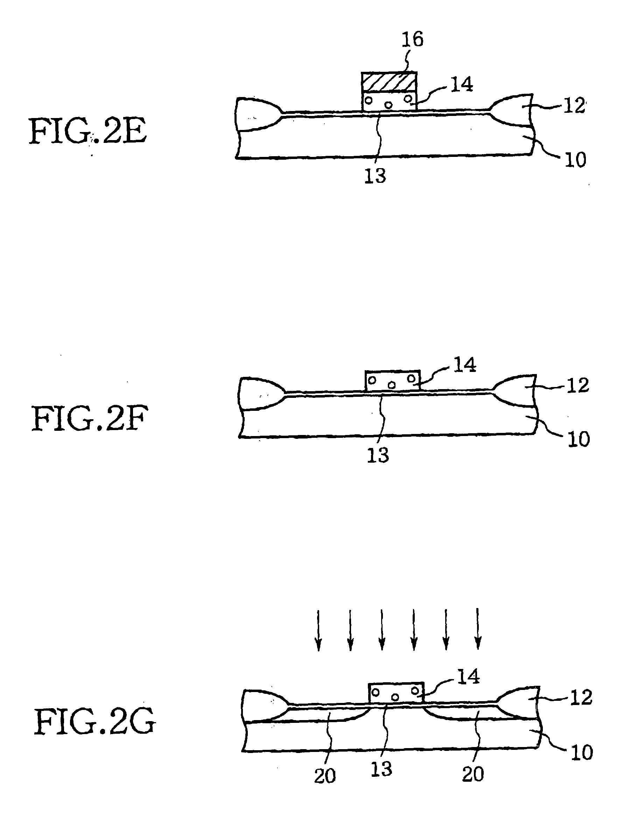

Then, with the patterned resist film 16 as a mask, the polycrystalline silicon film 14 is etched by reactive ion etching (FIG. 2E).

Next, the resist film 16 is removed, and the patterning of the polycrystalline silicon film 14 is completed (FIG. 2F).

Subsequently ion implantation is conducted with the polycrystalline silicon film 14 as a mask to form a source / drain diffusion 20, and a MOS transistor including the polycrystalline silicon film 14 as a gate electrode is fabricated (Fig. 2G).

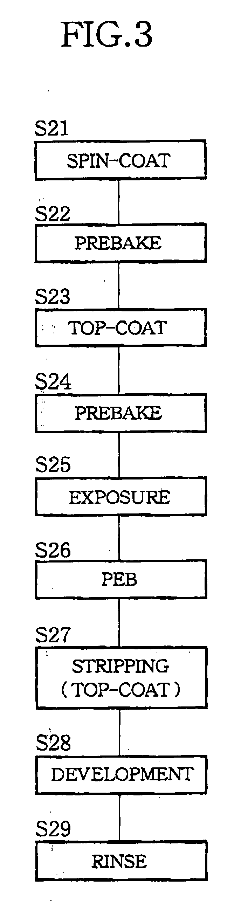

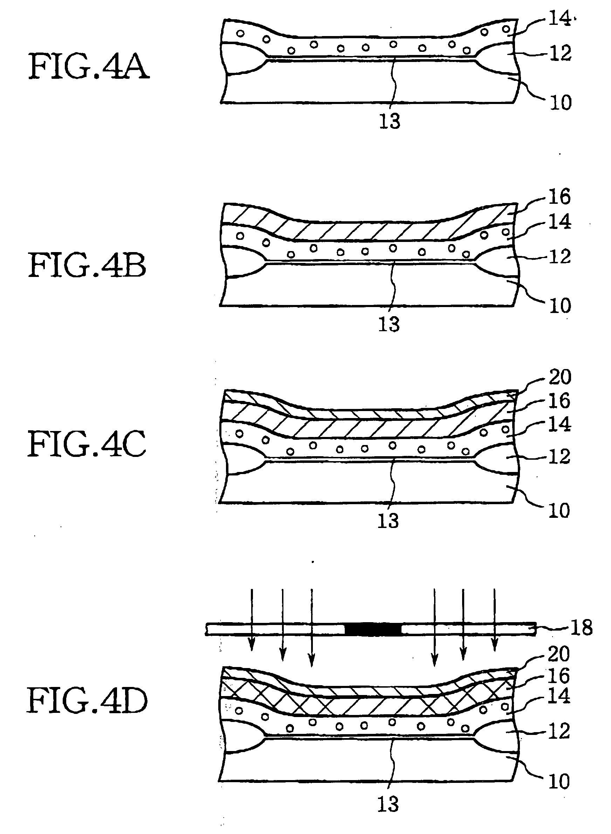

Another example of the semiconductor fabrication method according to the present invention will be explained with reference to FIGs. 3, and 4A to 4H.

In patterning a polycrystalline silicon film 14 deposited through an oxide film 13 on a semiconductor substrate 10 with a field isolation 12 formed on as shown in FIG. 4A, a resist film 16 is applied to the semiconductor substrate 10 with a polycrystalline silicon film 14 formed on (Step S21), and prebaked (Step S22, FIG. 4B).

Next, a protecting film 20 (top coat) is applied onto the semiconductor substrate 10 by spin coating (step S23), and prebaked (Step S24, Fig. 4C)

Then, the semiconductor substrate 10 with the resist film 16 and the protecting film 20 deposited on is exposed through a mask 18 for selective exposure (Step S25, FIG. 4D).

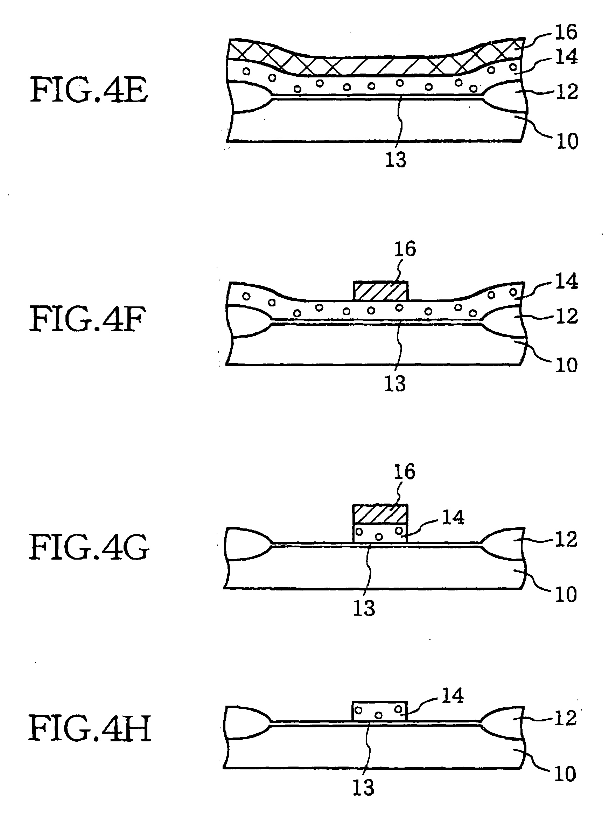

Following postbake (Step S26), chemical solution which can dissolve the protecting film 20 is applied onto the semiconductor substrate 10 by spin coating, and the protecting film 20 is stripped (Step S27, Fig. 4E).

Next, the resist film 16 is developed with a developer (Step S28) and patterned. Subsequently the semiconductor substrate 10 is rinsed with deionized water (Step S29). Thus the patterned resist film 16 is formed on the. semiconductor substrate 10 (FIG. 4F).

Then, with the patterned resist film 16 as a mask, the polycrystalline silicon film 14 is etched by reactive ion etching (FIG. 4G).

Next, the resist film 16 is removed, and the patterning of the polycrystalline silicon film 14 is completed (FIG. 4H).

As described above, subsequently ion implantation is conducted with the polycrystalline silicon film 14 as a mask to form a source / drain diffusion 20, and a MOS transistor including the polycrystalline silicon film 14 as a gate electrode is fabricated.

Accordingly micronized semiconductor device can be fabricated by excimer laser lithography, which can provide highly sensitive, stable patterning characteristics.

### [Example 1]

5 wt% of triphenylsulfonium triflate expressed by the following structural formula 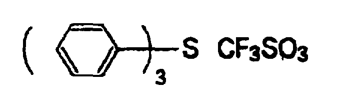 was added as an acid generating substance to vinylphenol - adamantyloxycarbonylmethyl styrene - tert-butyl methacrylate terpolymer expressed by the following structural formula 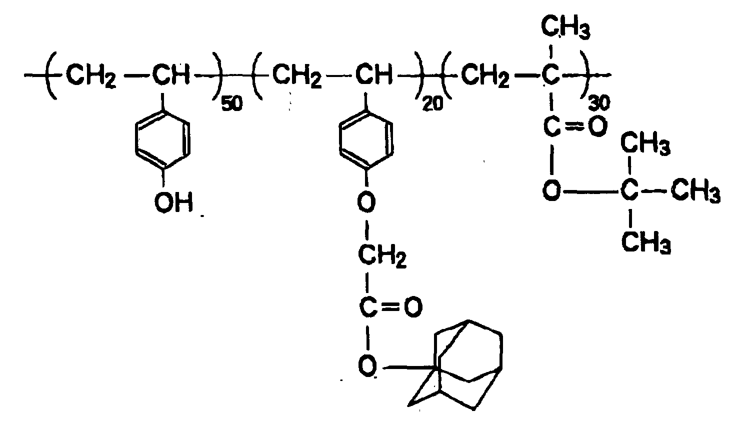 and having a 50:20:30 composition ratio, and an 18 wt% ethyl lactate solution was prepared. This solution was applied onto an Si wafer by spin coating and baked for 90 seconds on a hot plate at 110°C. A 0.7 µm-thickness resist film was formed.

The thus-prepared resist film on the wafer was exposed by a KrF excimer stepper and was subjected to PEB at 90°C for 60 seconds. Then the resist film was developed with a 2.38 % TMAH aqueous solution for 1 minute.

A 0.275 µm-wide L & S pattern was resolved at a 26 mJ/cm² radiation dose. When PEB was conducted after the resist was left for 30 minutes after the exposure, a 0.275 µm-wide L & S pattern was resolved at the same radiation dose.

### [Example 2]

5 wt% of triphenylsulfonium triflate expressed by the following structural formula 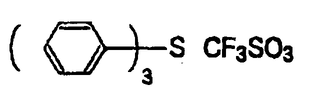 was added as an acid generating substance to vinylphenol - norbornyloxycarbonylmethyl styrene - tert-butyl methacrylate terpolymer expressed by the following structural formula 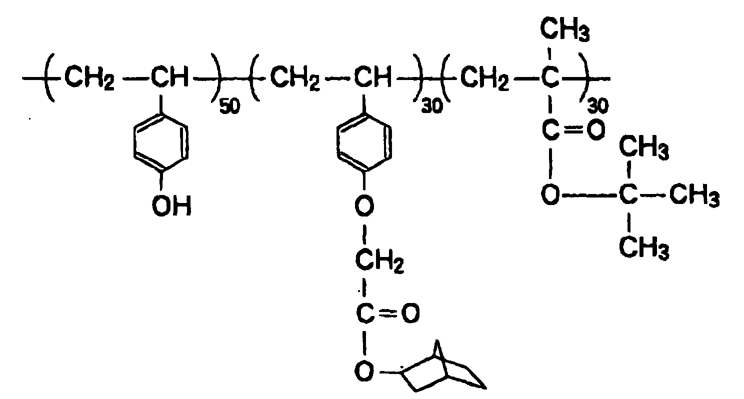 and having a 50:30:30 composition ratio, and an 18 wt% ethyl lactate solution was prepared. This solution was applied onto an Si wafer by spin coating and baked for 90 seconds on a hot plate at 110°C. A 0.7 µm-thickness resist film was formed.

The thus-prepared resist film on the wafer was exposed by a KrF excimer stepper and was subjected to PEB at 90°C for 60 seconds. Then the resist film was developed with a 2.38 % TMAH aqueous solution for 1 minute.

A 0.275 µm-wide L & S pattern was resolved at a 22 mJ/cm² radiation dose. When PEB was conducted after the resist was left for 30 minutes after the exposure, a 0.275 µm-wide L & S pattern was resolved at the same radiation dose.

### [Example 3 ]

5 wt% of triphenylsulfonium triflate expressed by the following structural formula 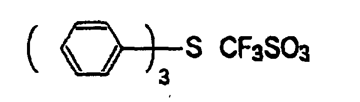 was added as an acid generating substance to vinylphenol - tert-butyl methacrylate copolymer (produced by Maruzen Sekiyu) expressed by the following structural formula 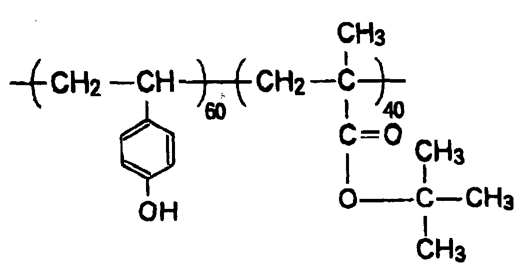 and having a 60:40 composition ratio, and 1-adamantane carboxylate t-butyl expressed by the following formula 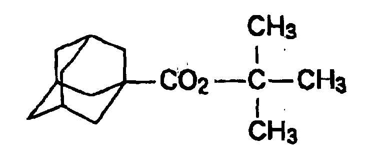 was also added by the same weight% as that of the copolymer, and an 18 wt% ethyl lactate solution was prepared. This solution was applied onto an Si wafer by spin coating and baked for 90 seconds on a hot plate at 110°C. A 0.7 µm-thickness resist film was formed.

The thus-prepared resist film on the wafer was exposed by a KrF excimer stepper and was subjected to PEB at 90°C for 60 seconds. Then the resist film was developed with a 2.38 % TMAH aqueous solution for 1 minute.

A 0.275 µm-wide L & S pattern was resolved at a 8.5 mJ/cm² radiation dose. When PEB was conducted after the resist was left for 30 minutes after the exposure, a 0.275 µm-wide L & S pattern was resolved at the same radiation dose.

The threshold energy Eth of the radiation dose when PEB was conducted immediately after the exposure was 5.5 mJ/cm². The Eth did not substantially change after post exposure 30 minutes delay.

### [Example 4]

5 wt% of triphenylsulfonium triflate expressed by the following structural formula 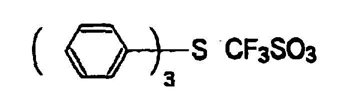 was added as an acid generating substance to vinylphenol - tert-butyl methacrylate copolymer (produced by Maruzen Sekiyu) expressed by the following structural formula 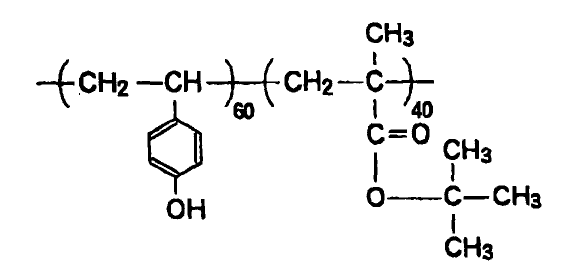 and having a 60:40 composition ratio, and di-t-butyl fumarate expressed by the following formula 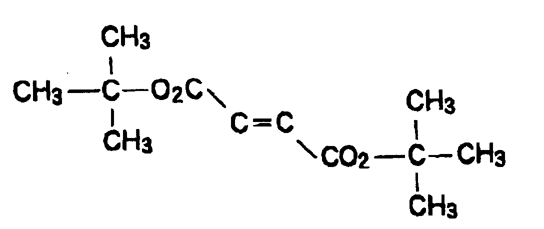 was also added by the same weight% as that of the copolymer, and an 18 wt% ethyl lactate solution was prepared. This solution was applied onto an Si wafer by spin coating and baked for 90 seconds on a hot plate at 110°C. A 0.7 µm-thickness resist film was formed.

The thus-prepared resist film on the wafer was exposed by a KrF excimer stepper and was subjected to PEB at 90°C for 60 seconds. Then the resist film was developed with a 2.38 % TMAH aqueous solution for 1 minute.

A 0.275 µm-wide L.& S pattern was resolved at a 12 mJ/cm² radiation dose. When PEB was conducted after the resist was left for 30 minutes after the exposure, a 0.275 µm-wide L & S pattern was resolved at the same radiation dose.

The threshold energy Eth of the radiation dose when PEB was conducted immediately after the exposure was 8 mJ/cm². The Eth did not substantially change after post exposure 30 minutes delay.

### [Example 5 ]

5 wt% of diphenyliodonium triflate expressed by the following structural formula 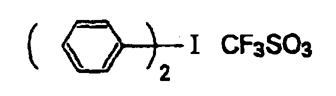 was added as an acid generating substance to vinylphenol - tert-butyl methacrylate copolymer (produced by Maruzen Sekiyu) expressed by the following structural formula 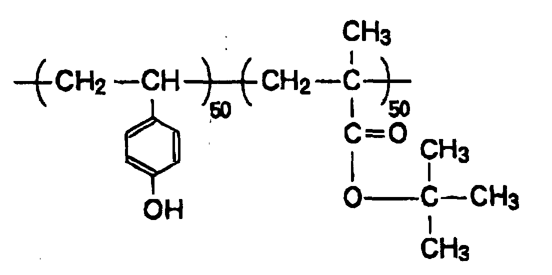 and having a 50:50 composition ratio, and di-t-butyl fumarate expressed by the following formula 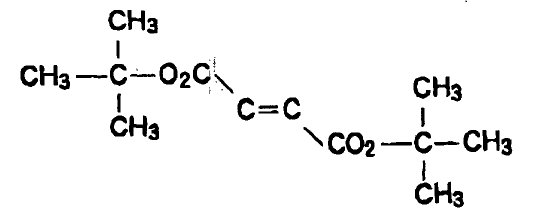 was also added by the same weight% as that of the copolymer, and an 18 wt% ethyl lactate solution was prepared. This solution was applied onto an Si wafer by spin coating and baked for 90 seconds on a hot plate at 110°C. A 0.7 µm-thickness resist film was formed.

The thus-prepared resist film on the wafer was exposed by a KrF excimer stepper and was subjected to PEB at 90°C for 60 seconds. Then the resist film was developed with a 2.38 % TMAH aqueous solution for 1 minute.

A 0.275 µm-wide L & S pattern was resolved at a 18 mJ/cm² radiation dose. When PEB was conducted after the resist was left for 30 minutes after the exposure, a 0.275 µm-wide L & S pattern was resolved with at same radiation dose.

The threshold energy Eth of the radiation dose when PEB was conducted immediately after the exposure was 8 mJ/cm². The Eth did not substantially change after post exposure 30 minutes delay.

### [Example 6 ]

5 wt% of triphenylsulfonium triflate expressed by the following structural formula 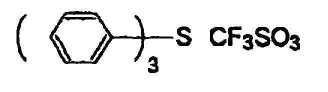 was added as an acid generating substance to vinylphenol - tert-butoxycarbonyloxystyrene copolymer (produced by Maruzen Sekiyu) expressed by the following structural formula 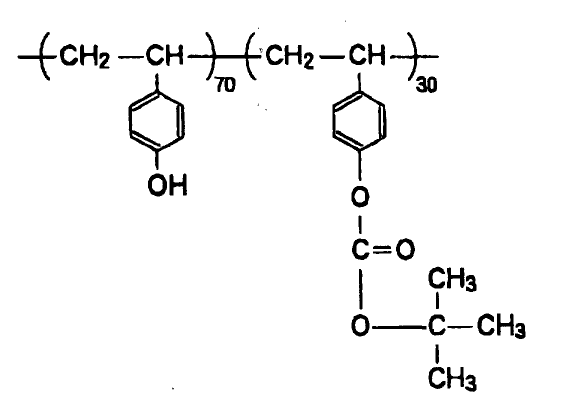 and having a 70:30 composition ratio, and 1-adamantane carboxylate t-butyl expressed by the following formula 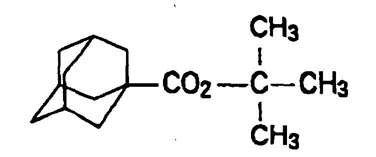 was also added by the same weight% as that of the copolymer, and an 18 wt% ethyl lactate solution was prepared. This solution was applied onto an Si wafer by spin coating and baked for 90 seconds on a hot plate at 110°C. A 0.7 µm-thickness resist film was formed.

The thus-prepared resist film on the wafer was exposed by a KrF excimer stepper and was subjected to PEB at 90°C for 60 seconds. Then the resist film was developed with a 2.38 % TMAH aqueous solution for 1 minute.

A 0.275 µm-wide L & S pattern was resolved at a 35 mJ/cm² radiation dose. When PEB was conducted after the resist was left for 30 minutes after the exposure, a 0.275 µm-wide L & S pattern was resolved with at same radiation dose.

### [Control 1 ]

5 wt% of triphenylsulfonium triflate expressed by the following structural formula 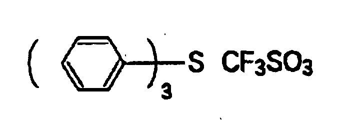 was added as an acid generating substance to vinylphenol - tert-butyl methacrylate copolymer (produced by Maruzen Sekiyu) expressed by the following structural formula 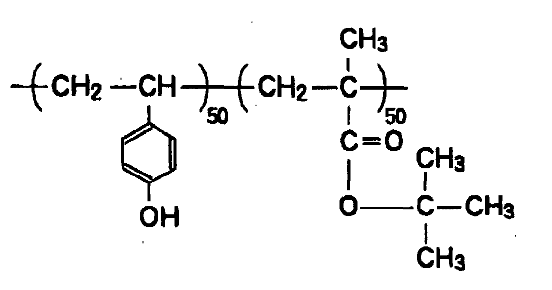 and having a 50:50 composition ratio, and an 18 wt% ethyl lactate solution was prepared. This solution was applied onto an Si wafer by spin coating and baked for 90 seconds on a hot plate at 110°C. A 0.7 µm-thickness resist film was formed.

The thus-prepared resist film on the wafer was exposed by a KrF excimer stepper and was subjected to PEB at 90°C for 60 seconds. Then the resist film was developed with a 2.38 % TMAH aqueous solution for 1 minute.

A 0.275 µm-wide L & S pattern was resolved at a 13 mJ/cm² radiation dose. When PEB was conducted for 60 seconds at 90°C after the resist was left for 5 minutes after the exposure, the surface became insoluble, and a 0.275 µm-wide L & S pattern could not be resolved at the same radiation dose.

### [Control 2]

5 wt% of triphenylsulfonium triflate expressed by the following structural formula 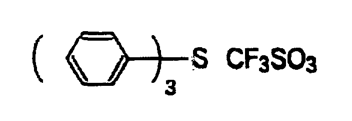 was added as an acid generating substance to vinylphenol - tert-butyl methacrylate copolymer (produced by Maruzen Sekiyu) expressed by the following structural formula 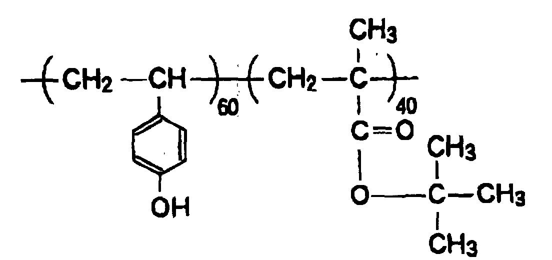 and having a 60:40 composition ratio, and an 18 wt% ethyl lactate solution was prepared. This solution was applied onto an Si wafer by spin coating and baked for 90 seconds on a hot plate at 110°C. A 0.7 µm-thickness resist film was formed.

The thus-prepared resist film on the wafer was exposed by a KrF excimer stepper and was subjected to PEB at 90°C for 60 seconds. Then the resist film was developed with a 2.38 % TMAH aqueous solution for 1 minute.

A 0.3 µm-wide L & S pattern was resolved at an 8 mJ/cm² radiation dose. When PEB was conducted for 60 seconds at 90°C after the resist was left for 10 minutes after the exposure, the surface became insoluble, and a 0.3 µm-wide L & S pattern could not be resolved at the same radiation dose.

The threshold energy Eth of the radiation dose when PEB was conducted immediately after the exposure was 5.5 mJ/cm², but the Eth in the case of the resist was 10 mJ/cm² after post exposure 30 minutes delay.

### [Control 3 ]

5 wt% of triphenylsulfonium triflate expressed by the following structural formula 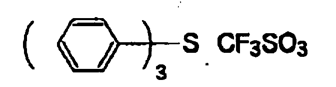 was added as an acid generating substance to vinylphenol - tert-butoxycarbonyloxystyrene copolymer expressed by the following structural formula 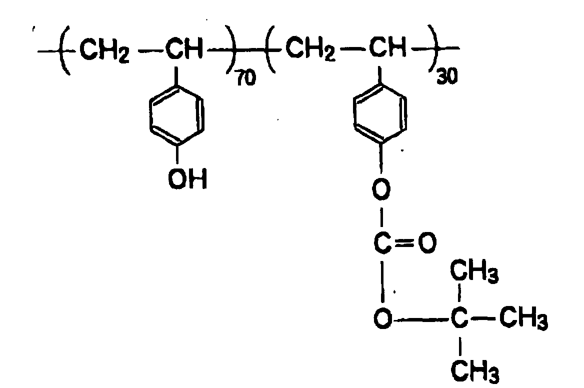 and having a 70:30 composition ratio, and an 18 wt% ethyl lactate solution was prepared. This solution was applied onto an Si wafer by spin coating and baked for 90 seconds on a hot plate at 110°C. A 0.7 µm-thickness resist film was formed.

The thus-prepared resist film on the wafer was exposed by a KrF excimer stepper and was subjected to PEB at 90°C for 60 seconds. Then the resist film was developed with a 2.38 % TMAH aqueous solution for 1 minute.

A 0.275 µm-wide L & S pattern was resolved at a 30 mJ/cm² radiation dose. When PEB was conducted for 60 seconds at 90°C after the resist was left for 10 minutes after the exposure, the surface became insoluble, and a 0.275 µm-wide L & S pattern could not be resolved at the same radiation dose.

### [Example 7]

t-butyl methacrylate monomer and itaconic anhydride monomer were loaded in a ratio of 1:1, and a 2 mol/l solution of 1,4-dioxane solution was prepared. Then 5 mol% of AIBN was added to the solution. Then polymerization took place for about 10 hours at 80°C. After the polymerization precipitation purification was conducted with n-hexane. The copolymer expressed by the following structural formula 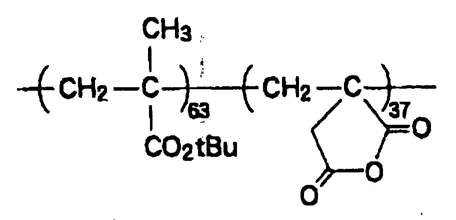 and having a 63:37 composition ratio, a 6500 weigh-average molecular weight and a 2.23 degree of dispersion was prepared.

Then to the thus-synthesized polymer, 15 wt% of triphenylsulfonium hexafluoroantimonate as an acid generating substance expressed by the following structural formula 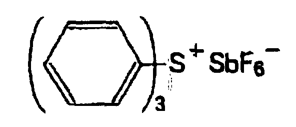 was added, and a cyclohexanone solution was prepared. This solution was applied onto a silicon wafer in a 0.7 µm-thickness by spin coating, and the wafer was prebaked on a hot plate at 100°C for 100 seconds.

The thus-prepared resist film on the wafer was exposed by a KrF excimer stepper and then subjected to PEB at 100°C for 60 seconds. Subsequently the resist was developed for 60 seconds with a solution of NMD-3, an alkali aqueous solution and water (volume ratio; NMD-3:water = 1:5), and then rinsed with deionized water for 30 seconds. The threshold energy Eth of the radiation dose for this exposure was 17 mJ/cm². A minimum resolution was a 0.275 µm-wide L & S pattern. No pattern peeling or falls were observed.

When, in place of the 1:5 volume ratio solution of NMD-3 and water, a volume ratio 1:10 solution of NMD-3 and water and a 1:20 volume ratio solution of NMD-3 and water were used, the same results were obtained.

### [Control 4]

A 2 mol% 1,4-dioxane solution of t-butyl methacrylate monomer was prepared, and 5 mol% of AIBN was added as a polymerization initiator. Polymerization took place for about 10 hours at 80°C. Following the polymerization, precipitation purification was conducted with a solution of methanol and water (methanol : water = 3:1). And the polymer expressed by the following structural formula 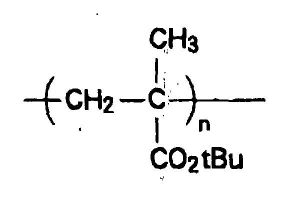 and having a 10097 weight-average molecular weight and a 1.88 degree of dispersion was prepared.

Then 15 wt% of triphenylsulfonium hexafluoroantimonate expressed by the following formula 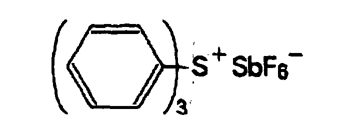 was added to the thus-synthesized polymer as an acid generating substance, and a cyclohexanone solution was prepared. This solution was applied onto a silicon wafer in a 0.7 µm-thickness by spin coating and was prebaked for 100 seconds on a hot plate at 100°C.

The thus-prepared resist film on the wafer was exposed by a KrF excimer stepper and then subjected to PEB at 100°C for 60 seconds. Subsequently the resist was developed for 60 seconds with a solution of NMD-3, an alkali aqueous solution), and then rinsed with deionized water for 30 seconds. The threshold energy Eth of the radiation dose for this exposure was 17 mJ/cm². A minimum resolution was a 0.35 µm-wide L & S pattern with 56 mJ/cm². L & S patterns below 0.35 µm-wide peeled and vanished.

When a 1:5 volume ratio solution of NMD-3 and water was used as a developer in place of NMD-3, the threshold value energy Eth of the radiation dose was 16.1 mJ/cm². A minimum resolution was a 0.3 µm-wide L & S pattern with 56 mJ/cm². L & S patterns below 0.3 µm-wide peeled and vanished.

### [Example 8]

Adamantyl methacrylate monomer, t-butyl acrylate monomer and itaconic anhydride monomer were loaded by 4:2:4, and a 1 mol/l 1,4-dioxane solution was prepared. 10 mol% of AIBN as a polymerization initiator was added to the solution. Then polymerization took place for about 8 hours at 80°C. Following the polymerization, precipitation purification was conducted with methanol. The copolymer expressed by the following structural formula 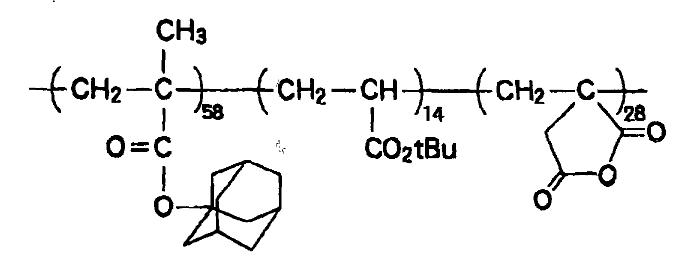 and having a 58:14:28 composition ratio, a 13000 weight-average molecular weight and a 1.81 degree of dispersion was prepared.

15 wt% of triphenylsulfonium hexafluoroantimonate expressed by the following structural formula 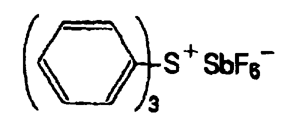 was added, and a cyclohexanone solution was prepared. This solution was applied to a silicon wafer in a 0.7 µm-thickness by spin coating, and then prebaked for 100 seconds on a hot plate at 100°C.

The thus-prepared resist film on the wafer was exposed by a KrF excimer stepper and then subjected to PEB at 130°C for 60 seconds. Subsequently the resist was developed for 60 seconds with a solution of NMD-3, an alkali aqueous solution, and then rinsed with deionized water for 30 seconds. The threshold energy Eth of the radiation dose for this exposure was 17 mJ/cm². A minimum resolution was a 0.25 µm-wide L & S pattern with 50 mJ/cm². No pattern peeling or falls were observed.

When PEB was subjected at 100°C for 100 seconds, and a 5:1 volume ratio solution of NMD-3 and isopropyl alcohol was used as a developer in place of NMD-3, the threshold value energy Eth of the radiation dose was 25.5 mJ/cm². A minimum resolution was a 0.275 µm-wide L & S pattern with 44 mJ/cm². No pattern peeling or falls were observed.

### [Control 5]

Adamantyl methacrylate monomer and t-butyl acrylate monomer were loaded by 1:1, and a 5 mol/l toluene solution was prepared. 20 mol% of AIBN as a polymerization initiator was added to the solution. Then polymerization took place for about 8 hours at 80°C. Following the polymerization, precipitation purification was conducted with methanol. The copolymer expressed by the following structural formula 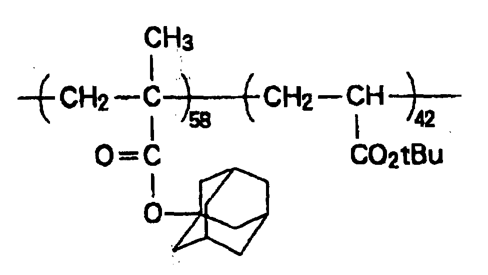 and having a 58:42 composition ratio, a 5100 weight-average molecular weight and a 1.43 degree of dispersion was prepared. The glass transition temperature of this polymer was 126°C by thermal analysis.

15 wt% of triphenylsulfonium hexafluoroantimonate expressed by the following structural formula 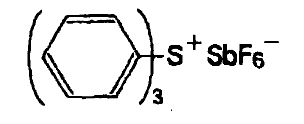 was added, and a cyclohexanone solution was prepared. This solution was applied to a silicon wafer in a 0.7 µm-thickness by spin coating, and then prebaked for 100 seconds on a hot plate at 60°C.

The thus-prepared resist film on the wafer was exposed by a KrF excimer stepper and then subjected to PEB at 100°C for 60 seconds. Subsequently the resist was developed for 60 seconds with a solution of NMD-3, an alkali aqueous solution, and then rinsed with deionized water for 30 seconds. The threshold energy Eth of the radiation dose for this exposure was 50 mJ/cm². A minimum resolution was a 0.45 µm-wide L & S pattern with 30 mJ/cm². Resist residues between patterns were striking, and pattern peeling or falls were observed.

### [Example 9]

Dimethyladamantyl methacrylate monomer, t-butyl acrylate monomer and itaconic anhydride monomer were loaded by 4:2:4, and a 1 mol/l 1,4-dioxane solution was prepared. 10 mol% of AIBN as a polymerization initiator was added to the solution. Then polymerization took place for about 8 hours at 80°C. Following the polymerization, precipitation purification was conducted with methanol. The copolymer expressed by the following structural formula 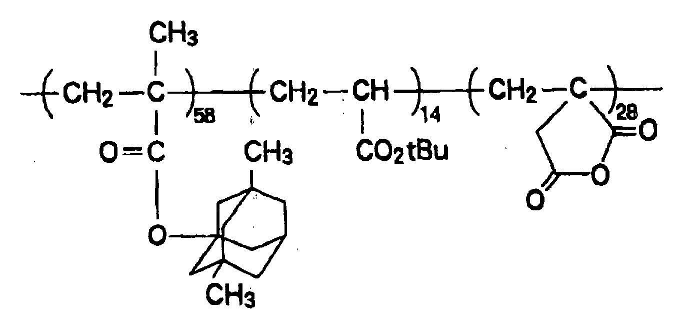 and having a 58:14:28 composition ratio, a 13000 weight-average molecular weight and a 1.81 degree of dispersion was prepared.

15 wt% of triphenylsulfonium hexafluoroantimonate expressed by the following structural formula 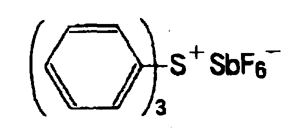 was added, and a cyclohexanone solution was prepared. This solution was applied to a silicon wafer in a 0.7 µm-thickness by spin coating, and then prebaked for 100 seconds on a hot plate at 100°C.

The thus-prepared resist film on the wafer was exposed by a KrF excimer stepper and then subjected to PEB at 130°C for 60 seconds. Subsequently the resist was developed for 60 seconds with a solution of NMD-3, an alkali aqueous solution, and then rinsed with deionized water for 30 seconds. The threshold energy Eth of the radiation dose for this exposure was 17 mJ/cm². A minimum resolution was a 0.25 µm-wide L & S pattern with 50 mJ/cm². No pattern peeling or falls were observed.

### [Example 10]

Adamantyl methacrylate monomer, t-butyl α-chloroacrylate monomer and itaconic anhydride monomer were loaded by 4:2:4, and a 1 mol/l 1,4-dioxane solution was prepared. 10 mol% of AIBN as a polymerization initiator was added to the solution. Then polymerization took place for about 8 hours at 80°C. Following the polymerization, precipitation purification was conducted with methanol. The copolymer expressed by the following structural formula 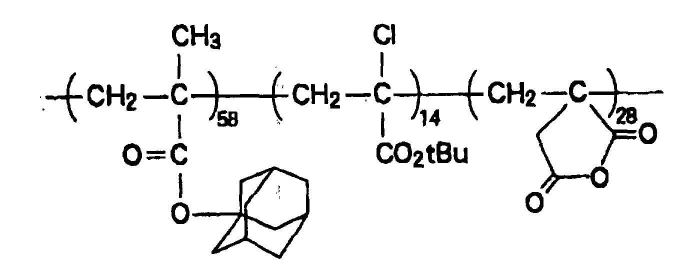 and having a 58:14:28 composition ratio, a 13000 weight-average molecular weight and a 1.81 degree of dispersion was prepared.

15 wt% of triphenylsulfonium hexafluoroantimonate expressed by the following structural formula 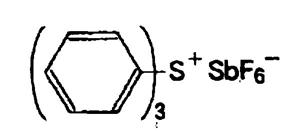 was added, and a cyclohexanone solution was prepared. This solution was applied to a silicon wafer in a 0.7 µm-thickness by spin coating, and then prebaked for 100 seconds on a hot plate at 100°C.

The thus-prepared resist film on the wafer was exposed by a KrF excimer stepper and then subjected to PEB at 130°C for 60 seconds. Subsequently the resist was developed for 60 seconds with a solution of NMD-3, an alkali aqueous solution, and then rinsed with deionized water for 30 seconds. The threshold energy Eth of the radiation dose for this exposure was 17 mJ/cm². A minimum resolution was a 0.25 µm-wide L & S pattern with 50 mJ/cm². No pattern peeling or falls were observed.

### [Control 6]

Adamantyl methacrylate monomer and t-butyl α-chloroacrylate monomer were loaded by 1:1, and a 5 mol/l toluene solution was prepared. 10 mol% of AIBN as a polymerization initiator was added to the solution. Then polymerization took place for about 8 hours at 80°C. Following the polymerization, precipitation purification was conducted with methanol. The copolymer expressed by the following structural formula 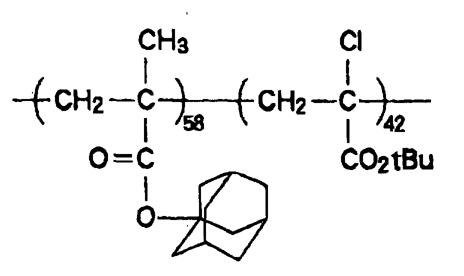 and having a 58:42 composition ratio, a 5100 weight-average molecular weight and a 1.43 degree of dispersion was prepared. The glass transition temperature of this polymer was 126°C.

15 wt% of triphenylsulfonium hexafluoroantimonate expressed by the following structural formula 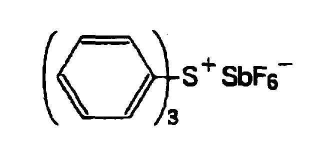 was added, and a cyclohexanone solution was prepared. This solution was applied to a silicon wafer in a 0.7 µm-thickness by spin coating, and then prebaked for 100 seconds on a hot plate at 60°C.

The thus-prepared resist film on the wafer was exposed by a KrF excimer stepper and then subjected to PEB at 100°C for 60 seconds. Subsequently the resist was developed for 60 seconds with a solution of NMD-3, an alkali aqueous solution, and then rinsed with deionized water for 30 seconds.

Serious pattern peeling took place, and a minimum resolution was a 0.5 µm-wide L & S pattern.

### [Example 11]

Adamantyl methacrylate monomer, α,α-dimethylbenzyl methacrylate monomer, and itaconic anhydride monomer were loaded by 4:2:4, and a 1 mol/l 1,4-dioxane solution was prepared. 10 mol% of AIBN as a polymerization initiator was added to the solution. Then polymerization took place for about 8 hours at 80°C. Following the polymerization, precipitation purification was conducted with methanol. The copolymer expressed by the following structural formula 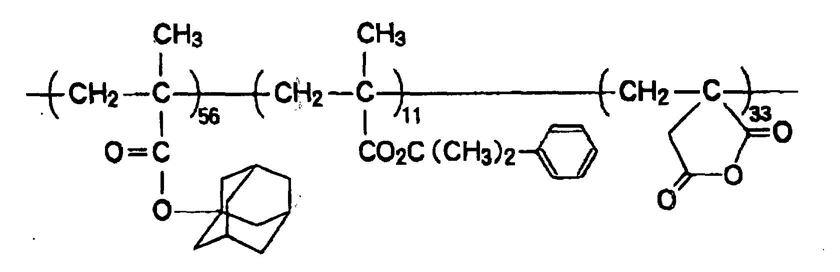 and having a 56:11:33 composition ratio, a 16000 weight-average molecular weight and a 1.91 degree of dispersion was prepared.

15 wt% of triphenylsulfonium hexafluoroantimonate expressed by the following structural formula 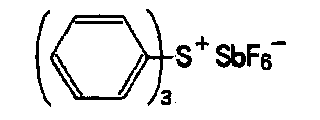 was added, and a cyclohexanone solution was prepared. This solution was applied to a silicon wafer in a 0.7 µm-thickness by spin coating, and then prebaked for 100 seconds on a hot plate at 100°C.

The thus-prepared resist film on the wafer was exposed by a KrF excimer stepper and then subjected to PEB at 100°C for 60 seconds. Subsequently the resist was developed for 60 seconds with a solution of NMD-3, an alkali aqueous solution, and then rinsed with deionized water for 30 seconds. The threshold energy Eth of the radiation dose for this exposure was 8 mJ/cm². A minimum resolution was a 0.275 µm-wide L & S pattern with 23 mJ/cm². No pattern peeling or falls were observed.

### [Example 12]

Adamantyl methacrylate monomer, 3-oxocyclohexyl methacrylate monomer, and itaconic anhydride monomer were loaded by 4:2:4, and a 1 mol/l 1,4-dioxane solution was prepared. 10 mol% of AIBN as a polymerization initiator was added to the solution. Then polymerization took place for about 8 hours at 80°C. Following the polymerization, precipitation purification was conducted with methanol. The copolymer expressed by the following structural formula 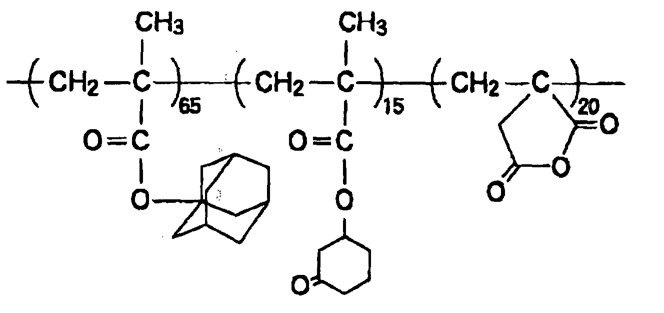 and having a 65:15:20 composition ratio, a 13200 weight-average molecular weight and a 1.92 degree of dispersion was prepared.

15 wt% of triphenylsulfonium hexafluoroantimonate expressed by the following structural formula 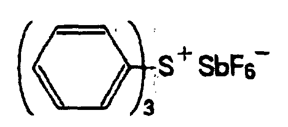 was added, and a cyclohexanone solution was prepared. This solution was applied to a silicon wafer in a 0.7 µm-thickness by spin coating, and then prebaked for 100 seconds on a hot plate at 100°C.

The thus-prepared resist film on the wafer was exposed by a KrF excimer stepper and then subjected to PEB at 130°C for 60 seconds. Subsequently the resist was developed for 60 seconds with a solution of NMD-3, an alkali aqueous solution, and then rinsed with deionized water for 30 seconds. The threshold energy Eth of the radiation dose for this exposure was 19.2 mJ/cm². A minimum resolution was a 0.25 µm-wide L & S pattern with 54 mJ/cm². No pattern peeling or falls were observed.

### [Control 7]

Adamantyl methacrylate monomer, 3-oxocyclohexyl methacrylate monomer were loaded by 1:1, and a 5 mol/l toluene solution was prepared. 20 mol% of AIBN as a polymerization initiator was added to the solution. Then polymerization took place for about 8 hours at 80°C. Following the polymerization, precipitation purification was conducted with methanol. The copolymer expressed by the following structural formula 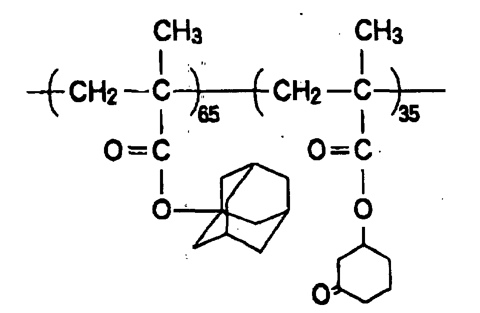 and having a 65:35 composition ratio, a 14400 weight-average molecular weight and a 1.53 degree of dispersion was prepared.

15 wt% of triphehylsulfonium hexafluoroantimonate expressed by the following structural formula 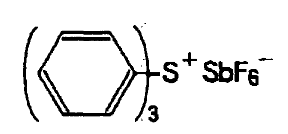 was added, and a cyclohexanone solution was prepared. This solution was applied to a silicon wafer in a 0.7 µm-thickness by spin coating, and then prebaked for 100 seconds on a hot plate at 60°C.

The thus-prepared resist film on the wafer was exposed by a KrF excimer stepper and then subjected to PEB at 100°C for 60 seconds. Subsequently the resist was developed for 60 seconds with a solution of NMD-3, an alkali aqueous solution, and then rinsed with deionized water for 30 seconds. The threshold energy Eth of the radiation dose for this exposure was 60.2 mJ/cm². A minimum resolution was a 0.4µm-wide L & S pattern with 208 mJ/cm². Much pattern peeling took place.

### [Example 13]

Adamantyl methacrylate monomer, tetrahydropyranyl methacrylate monomer, and itaconic anhydride monomer were loaded by 4:2:4, and a 1 mol/l 1,4-dioxane solution was prepared. 10 mol% of AIBN as a polymerization initiator was added to the solution. Then polymerization took place for about 8 hours at 80°C. Following the polymerization, precipitation purification was conducted with methanol. The copolymer expressed by the following structural formula 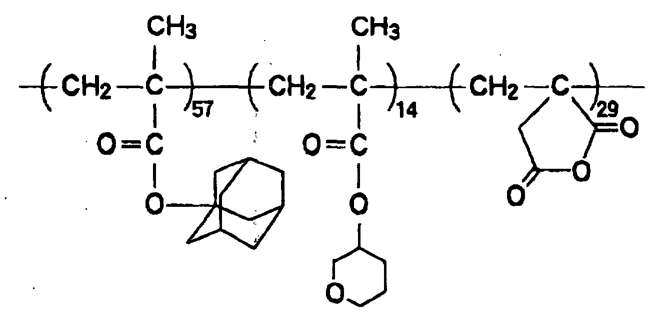 and having a 57:14:29 composition ratio, a 36200 weight-average molecular weight and a 2.14 degree of dispersion was prepared.

15 wt% of triphenylsulfonium hexafluoroantimonate expressed by the following structural formula 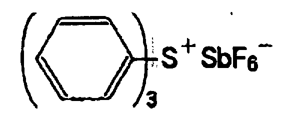 was added, and a cyclohexanone solution was prepared. This solution was applied to a silicon wafer in a 0.7 µm-thickness by spin coating, and then prebaked for 100 seconds on a hot plate at 100°C.

The thus-prepared resist film on the wafer was exposed by a KrF excimer stepper and then subjected to PEB at 130°C for 60 seconds. Subsequently the resist was developed for 60 seconds with a solution of NMD-3, an alkali aqueous solution, and then rinsed with deionized water for 30 seconds. The threshold energy Eth of the radiation dose for this exposure was 42.2 mJ/cm². A minimum resolution was a 0.30 µm-wide L & S pattern with 141 mJ/cm². No pattern peeling or falls were observed.

### [Control 8 ]

Adamantyl methacrylate monomer, tetrahydropyranyl methacrylate monomer were loaded by 1:1, and a 5 mol/l toluene solution was prepared. 20 mol% of AIBN as a polymerization initiator was added to the solution. Then polymerization took place for about 8 hours at 80°C. Following the polymerization, precipitation purification was conducted with methanol. The copolymer expressed by the following structural formula 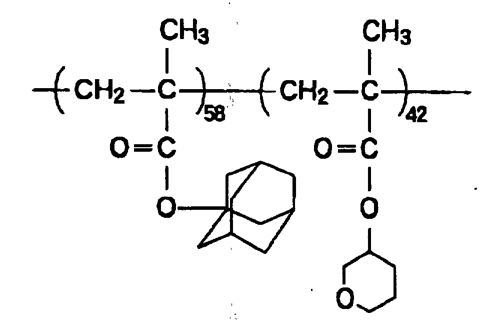 and having a 58:42 composition ratio, a 23000 weight-average molecular weight and a 1.90 degree of dispersion was prepared.

15 wt% of triphenylsulfonium hexafluoroantimonate expressed by the following structural formula 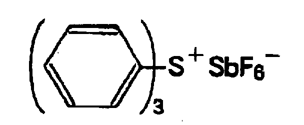 was added, and a cyclohexanone solution was prepared. This solution was applied to a silicon wafer in a 0.7 µm-thickness by spin coating, and then prebaked for 100 seconds on a hot plate at 60°C.

The thus-prepared resist film on the wafer was exposed by a KrF excimer stepper and then subjected to PEB at 100°C for 60 seconds. Subsequently the resist was developed for 60 seconds with a solution of NMD-3, an alkali aqueous solution, and then rinsed with deionized water for 30 seconds. No pattern could be formed.

### [Example 14]

Adamantyl methacrylate monomer, t-butoxystyrene monomer and itaconic anhydride monomer were loaded by 4:2:4, and a 1 mol/l 1,4-dioxane solution was prepared. 10 mol% of AIBN as a polymerization initiator was added to the solution. Then polymerization took place for about 8 hours at 80°C. Following the polymerization, precipitation purification was conducted with methanol. The terpolymer expressed by the following structural formula 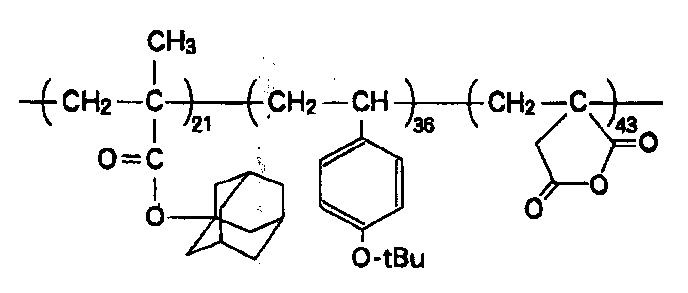 and having a 21:36:43 composition ratio, a 8200 weight-average molecular weight and a 1.95 degree of dispersion was prepared.

15 wt% of triphenylsulfonium hexafluoroantimonate expressed by the following structural formula 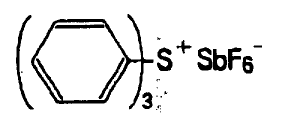 was added, and a cyclohexanone solution was prepared. This solution was applied to a silicon wafer in a 0.7 µm-thickness by spin coating, and then prebaked for 100 seconds on a hot plate at 100°C.

The thus-prepared resist film on the wafer was exposed by a KrF excimer stepper and then subjected to PEB at 130°C for 60 seconds. Subsequently the resist was developed for 60 seconds with a solution of NMD-3, an alkali aqueous solution, and then rinsed with deionized water for 30 seconds. No pattern peeling or falls were observed.

### [Example 15]

Adamantyl methacrylate monomer, t-BOC styrene monomer and itaconic anhydride monomer were loaded by a 4:2:4 ratio, and a 1 mol/l 1,4-dioxane solution was prepared. 10 mol% of AIBN as a polymerization initiator was added to the solution. Then polymerization took place for about 8 hours at 80°C. Following the polymerization, precipitation purification was conducted with methanol. The terpolymer expressed by the following structural formula 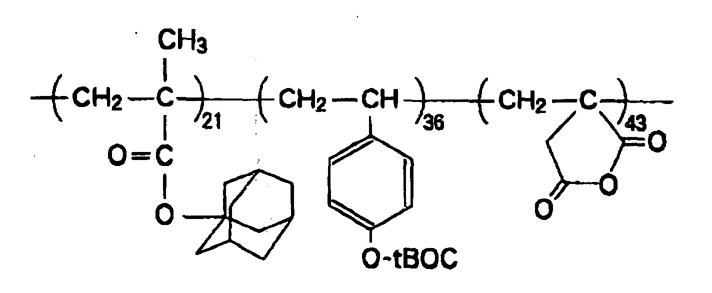 and having a 21:36:43 composition ratio, a 8200 weight-average molecular weight and a 1.95 degree of dispersion was prepared.

15 wt% of triphenylsulfonium hexafluoroantimonate expressed by the following structural formula 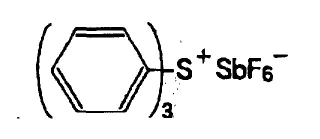 was added, and a cyclohexanone solution was prepared. This solution was applied to a silicon wafer in a 0.7 µm-thickness by spin coating, and then prebaked for 100 seconds on a hot plate at 100°C.

The thus-prepared resist film one the wafer was exposed by a KrF excimer stepper and then subjected to PEB at 130°C for 60 seconds. Subsequently the resist was developed for 60 seconds with a solution of NMD-3, an alkali aqueous solution, and then rinsed with deionized water for 30 seconds. No pattern peeling or falls were observed.

### [Example 16]

Itaconic anhydride monomer and di-t-butyl itaconate monomer were loaded in a 2:3 ratio, and 20 mol% of dimethyl 2,2-azoisobisbutyrate was added as a polymerization initiator. Then, bulk polymerization took place for about 3 hours at 80°C. After e polymerization, precipitation purification was conducted with methanol. The copolymer expressed by the following structural formula 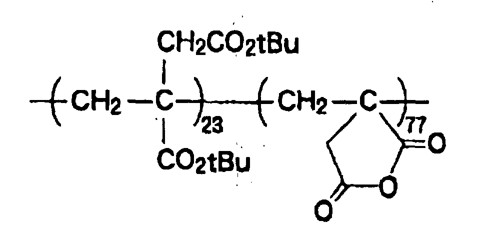 and having a 23:77 composition ratio, a 6357 weight-average molecular weight and 2.34 degree of dispersion was prepared.

15 wt% of triphenylsulfonium hexafluoroantimonate expressed by the following structural formula 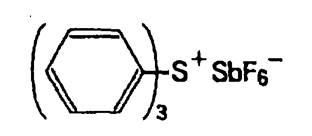 was added, and a cyclohexanone solution was prepared. This solution was applied to a silicon wafer in a 0.7 µm-thickness by spin coating, and then prebaked for 100 seconds on a hot plate at 60°C.

The thus-prepared resist film on the wafer was exposed by a KrF excimer stepper and then subjected to PEB at 100°C for 60 seconds. Subsequently the resist was developed for 60 seconds with a solution of NMD-3, an alkali aqueous solution, and then rinsed with deionized water for 30 seconds. The threshold energy of the radiation dose was 12.6 mJ/cm². A minimum resolution was a 0.3 µm-wide L & S pattern with 38 mJ/cm². No pattern peeling or falls were observed.

### [Example 17]

Itaconic anhydride monomer and di-t-butyl fumarate monomer were loaded in a 2:3 ratio, and 20 mol% of dimethyl 2,2-azoisobisbutyrate was added as a polymerization initiator. Then, bulk polymerization took place for about 3 hours at 80°C. After e polymerization, precipitation purification was conducted with methanol. The copolymer expressed by the following structural formula 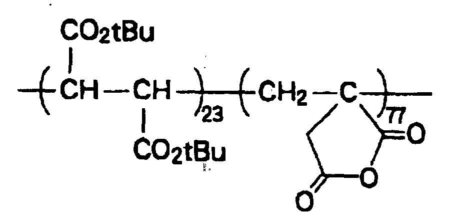 and having a 23:77 composition ration, a 6357 weight-average molecular weight and 2.34 degree of dispersion was prepared.

15 wt% of triphenylsulfonium hexafluoroantimonate expressed by the following structural formula 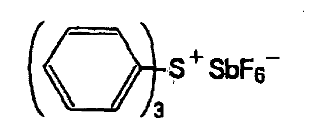 was added, and a cyclohexanone solution was prepared. This solution was applied to a silicon wafer in a 0.7 µm-thickness by spin coating, and then prebaked for 100 seconds on a hot plate at 60°C.

The thus-prepared resist film on the wafer was exposed by a KrF excimer stepper and then subjected to PEB at 100°C for 60 seconds. Subsequently the resist was developed for 60 seconds with a solution of NMD-3, an alkali aqueous solution, and then rinsed with deionized water for 30 seconds. The threshold energy of the radiation dose was 12.6 mJ/cm². A minimum resolution was a 0.3 µm-wide L & S pattern with 38 mJ/cm². No pattern peeling or falls were observed.

### [Example 18]

Methacrylonitrile monomer, t-butyl methacrylate monomer and itaconic anhydride monomer were loaded by 4:2:4, and a 5 mol/l 1,4-dioxane solution was prepared. 1 mol% of AIBN as a polymerization initiator was added to the solution. Then polymerization took place for about 8 hours at 80°C. Following the polymerization, precipitation purification was conducted with n-hexane. The terpolymer expressed by the following structural formula 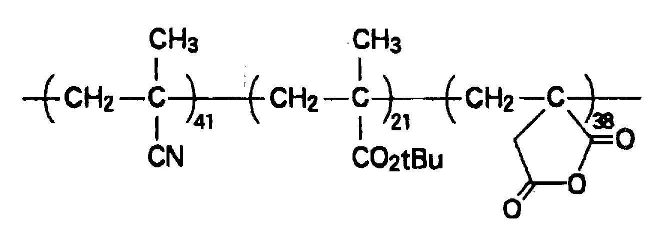 and having a 41:21:38 composition ratio, a 26400 weight-average molecular weight and a 1.87 degree of dispersion was prepared.

15 wt% of triphenylsulfonium hexafluoroantimonate expressed by the following structural formula 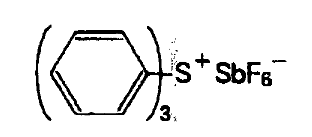 was added, and a cyclohexanone solution was prepared. This solution was applied to a silicon wafer in a 0.7 µm-thickness by spin coating, and then prebaked for 100 seconds on a hot plate at 100°C.

The thus-prepared resist film on the wafer was exposed by a KrF excimer stepper and then subjected to PEB at 100°C for 60 seconds. Subsequently the resist was developed for 60 seconds with a 2.3 % TMAH aqueous solution. A 0.3 µm-wide L & S pattern was resolved at a 41 mJ/cm² radiation dose.

### [Control 9]

Methacrylonitrile monomer and t-butyl methacrylate monomer were loaded by 1:1, and a 5 mol/l 1,4-dioxane solution and 1 mol% of AIBN, a polymerization initiator were added. Then polymerization took place for about 8 hours at 80°C. Following the polymerization, precipitation purification was conducted with a mixed solution of methanol and water (methanol : water = 2:1). The copolymer expressed by the following structural formula 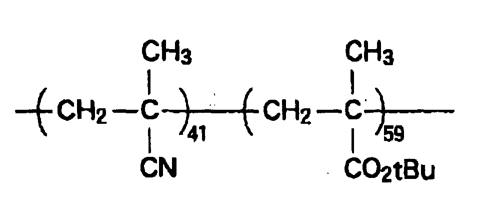 and having a 41:59 composition ratio, a 16400 weight-average molecular weight and a 1.77 degree of dispersion was prepared.

13 wt% of cyclohexanone solution of this copolymer was prepared, and triphenylsulfonium hexafluoroantimonate expressed by the following structural formula 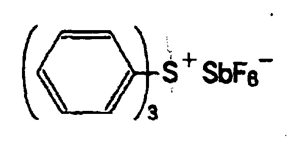 was added to this solution as a substance generating substance by 15 wt% to the polymer, and a resist solution was prepared. This solution was applied onto a silicon wafer by spin coating and prebaked for 100 seconds on a hot plate at 100°C. And a 0.7 µm-thickness thin film was formed.

The thus-prepared resist film on the wafer was exposed by a KrF excimer stepper and then subjected to PEB at 100°C for 60 seconds. Subsequently the resist was developed for 60 seconds with a 2.38 % TMAH aqueous solution. A 0.3 µm-wide L & S pattern was resolved at a 70 mJ/cm² radiation dose, but in comparison with that of the case without methacrylonitrile (Control 19), the sensitivity was lower.

### [Example 19]

Methyl α-cyanoacrylate monomer, t-butyl methacrylate monomer and itaconic anhydride were loaded by 4:2:4, and a 1 mol/l 1,4-dioxane solution was prepared. 10 mol% of AIBN as a polymerization initiator was added to the solution. Then polymerization took place for about 8 hours at 80°C. Following the polymerization, precipitation purification was conducted with methanol. The terpolymer expressed by the following structural formula 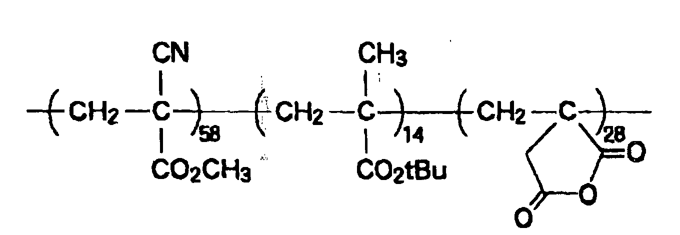 and having a 58:14:28 composition ratio, a 13000 weight-average molecular weight and a 1.81 degree of dispersion was prepared.

15 wt% of triphenylsulfonium hexafluoroantimonate expressed by the following structural formula 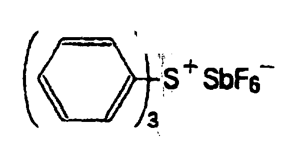 was added, and a cyclohexanone solution was prepared. This solution was applied to a silicon wafer in a 0.7 µm-thickness by spin coating, and then prebaked for 100 seconds on a hot plate at 100°C.

The thus-prepared resist film on the wafer was exposed by a KrF excimer stepper and then subjected to PEB at 130°C for 60 seconds. Subsequently the resist was developed for 60 seconds with NMD-3, an alkali aqueous solution and rinsed for 30 seconds with deionized water. The threshold energy of the radiation dose was 17 mJ/cm². A minimum resolution was a 0.25 µm-wide L & S pattern with 50 mJ/cm². No pattern peeling or falls were observed.

### [Example 20]

Adamantyl methacrylate monomer, t-amyl methacrylate monomer and itaconic anhydride were loaded by 4:2:4, and a 1 mol/l 1,4-dioxane solution was prepared. 10 mol% of AIBN as a polymerization initiator was added to the solution. Then polymerization took place for about 8 hours at 80°C. Following the polymerization, precipitation purification was conducted with methanol. The copolymer expressed by the following structural formula 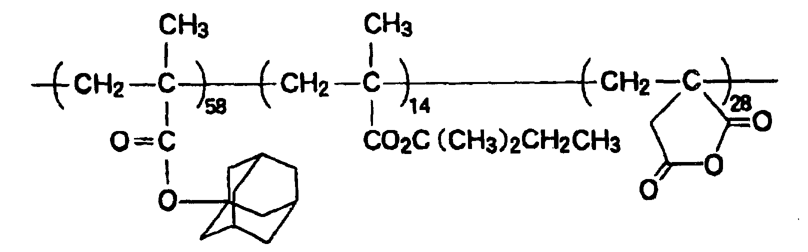 and having a 58:14:28 composition ratio, a 13000 weight-average molecular weight and a 1.81 degree of dispersion was prepared.

15 wt% of triphenylsulfonium hexafluoroantimonate expressed by the following structural formula 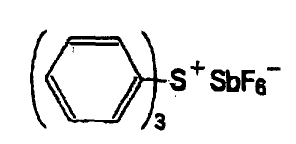 was added to the thus-synthesized polymer, and a cyclohexanone solution was prepared. This solution was applied to a silicon wafer in a 0.7 µm-thickness by spin coating, and then prebaked for 100 seconds on a hot plate at 100°C.

The thus-prepared resist film on the wafer was exposed by a KrF excimer stepper and then subjected to PEB at 130°C for 60 seconds. Subsequently the resist was developed for 60 seconds with NMD-3, an alkali aqueous solution and rinsed for 30 seconds with deionized water. The threshold energy of the radiation dose was 17 mJ/cm². A minimum resolution was a 0.25 µm-wide L & S pattern with 50 mJ/cm². No pattern peeling or falls were observed.

### [Example 20]

15 wt% of triphenylsulfonium hexafluoroantimonate as an acid generating substance was added to adamantyl methacrylate - t-butyl acrylate - itaconic anhydride terpolymer expressed by the following structural formula 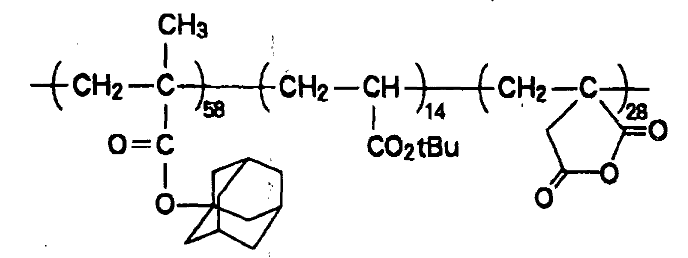 and having a 58:14:28 composition ratio, and a cyclohexanone solution was prepared. This resist solution was applied to a Si wafer by spin coating, and the wafer was prebaked for 100 seconds on a hot plate at 100°C, and a 0.7 µm-thickness resist film was formed.

A solution of 5 wt% of polyolefine resin in t-butylcyclohexane expressed by the following structural formula 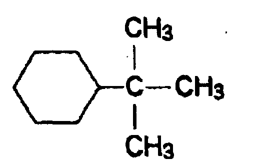 was applied onto the wafer by spin coating and baked for 100 seconds on a hot plate at 100°C, and a 0.2 µm-thickness protecting film was formed.

The thus-coated resist film on the wafer was exposed by a KrF excimer stepper and was subjected to PEB at 100°C for 60 seconds. Then cyclohexane was applied onto the wafer by spin coating, and the protecting film was removed.

Then the resist film was developed for 60 seconds with NMD-3, an alkali aqueous solution and rinsed for 30 seconds with deionized water. The threshold energy of the radiation dose was 13 mJ/cm². A 0.25 µm-wide L & S pattern was resolved at 41 mJ/cm².

### [Control 10]

15 wt% of triphenylsulfonium hexafluoroantimonate as an acid generating substance was added to adamantyl methacrylate - t-butyl acrylate copolymer expressed by the following structural formula 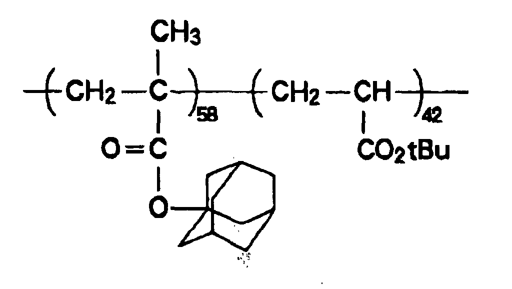 and having a 58:42 composition ratio, and a cyclohexanone solution was prepared. This resist solution was applied to a Si wafer by spin coating, and the wafer was prebaked for 100 seconds on a hot plate at 100°C, and a 0.7 µm-thickness resist film was formed.

A solution of 5 wt% of polyolefine resin in t-butylcyclohexane expressed by the following structural formula 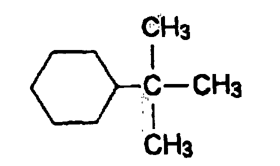 was applied onto the wafer by spin coating, and the resist thin film became opaque.

### [Control 11]

A 15 wt% of triphenylsulfonium hexafluoroantimonate as an acid generating substance was added to adamantyl methacrylate - t-butyl methacrylate - itaconic anhydride terpolymer expressed by the following structural formula 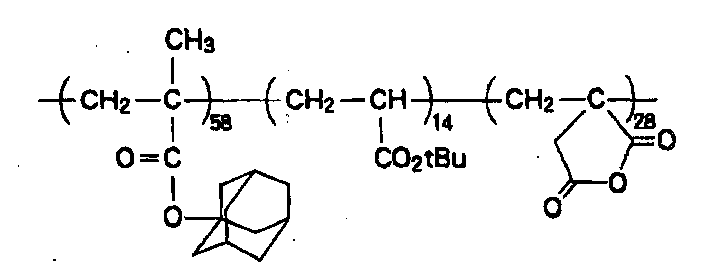 and having a 58:14:28 composition ratio and a cyclohexanone solution was prepared. This resist solution was applied to a Si wafer in a 7 µm-thickness by spin coating and prebaked for 100 seconds on a hot plate at 100°C.

A solution of 5 wt% of polyolefine resin in xylene was applied onto the wafer by spin coating, and the resist thin film was resolved.

Toluene and ethylene benzene were used as coating solvents in place of xylene, and similarly the resist thin films were resolved.

### [Example 21]

15 wt% of triphenylsulfonium hexafluoroantimonate as an acid generating substance was added to adamantyl methacrylate - t-butyl acrylate - itaconic anhydride terpolymer expressed by the following structural formula 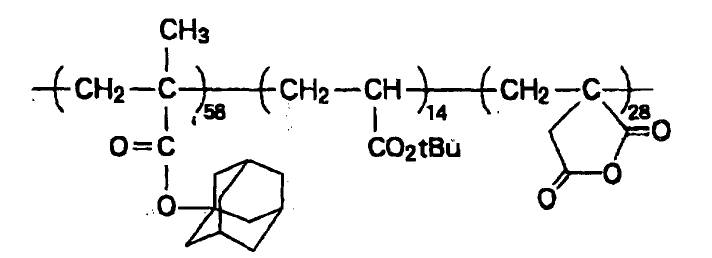 and having a 58:14:28 composition ratio, and a cyclohexanone solution was prepared. This resist solution was applied to a Si wafer in a 0.7 µm-thickness by spin coating, and prebaked for 100 seconds on a hot plate at 100°C.

A solution of 5 wt% of polyolefine resin in limonene expressed by the following structural formula 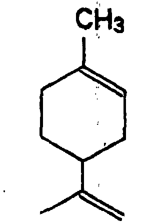 was applied onto the wafer by spin coating and baked for 100 seconds on a hot plate at 100°C, and a 0.2 µm-thickness protecting film was formed.

The thus-coated resist film on the wafer was exposed by a KrF excimer stepper and was subjected to PEB at 100°C for 60 seconds. Then cyclohexane was applied onto the wafer by spin coating, and the protecting film was removed.

Then the resist film was developed for 60 seconds with NMD-3, an alkali aqueous solution and rinsed for 30 seconds with deionized water. The threshold energy of the radiation dose was 13 mJ/cm². A 0.25 µm-wide L & S pattern was resolved at 41 mJ/cm².

The same resolving power was obtained by using as a coating solvent, in place of limonene, 1,5-cyclooctadiene expressed by the following structural formula 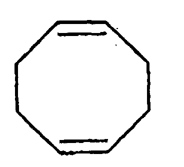 or using, 1-decene expressed by the following structural formula

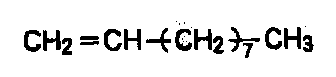

### [Control 12]

15 wt% of triphenylsulfonium hexafluoroantimonate as an acid generating substance was added to adamantyl methacrylate - t-butyl acrylate - itaconic anhydride terpolymer expressed by the following structural formula 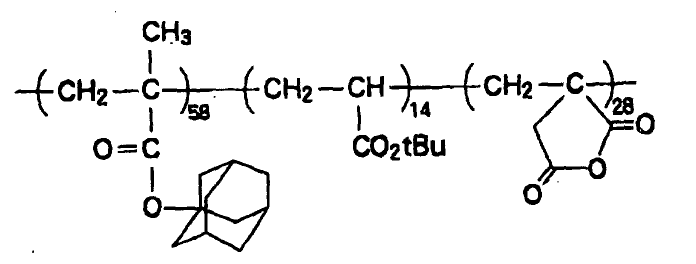 and having a 58:14:28 composition ratio, and a cyclohexanone solution was prepared. This resist solution was applied to a Si wafer in a 0.7 µm-thickness by spin coating, and prebaked for 100 seconds on a hot plate at 100°C.

A solution of 5 wt% of polyolefine resin in methylcyclohexane was applied onto the wafer by spin coating, and the solution did not uniformly spread over the wafer without forming a protecting film.

## Claims

1. A radiation sensitive material comprising a terpolymer expressed by a general formula 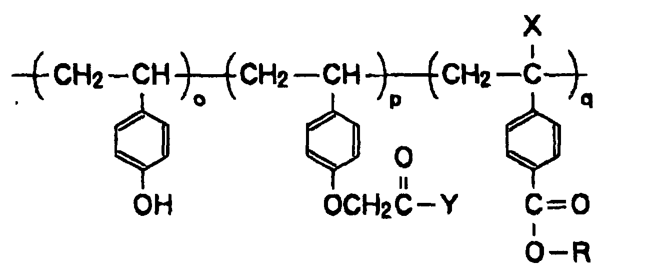 (where
X represents H or CH₃; Y is an alicyclic group;
R represents 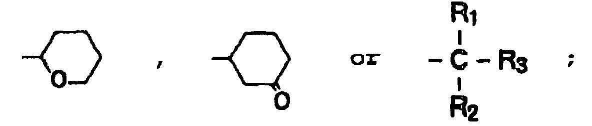 and
R₁ and R₂ represent H, R₃ represents 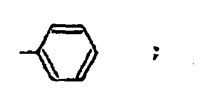
R₁ represents CH₃, R₂ represents H, R₃ represents 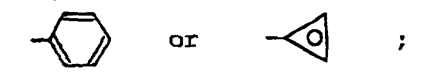
R₁ and R₂ represent CH₃, R₃ represents 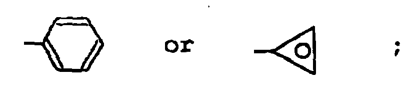 or
R₁, R₂ and R₃ represent CH₃); and
a substance generating an acid by application of radiation.

2. A radiation sensitive material comprising:
a resist containing a hydrophilic group; and
a hydrophobic compound.

3. A radiation sensitive material according to claim 2 , wherein
the resist containing a hydrophilic group is a copolymer expressed by a general formula 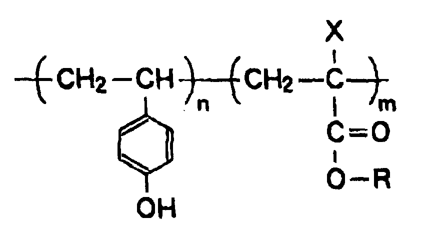
(where X represents H or CH₃;
R represents 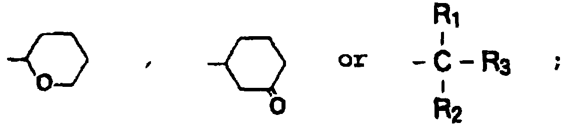 and
R₁ and R₂ represent H, R₃ represents 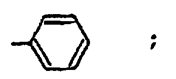
R₁ represents CH₃, R₂ represents H, R₃ represents 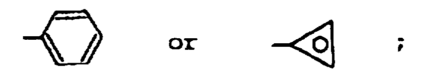
R₁ and R₂ represent CH₃, R₃ represents 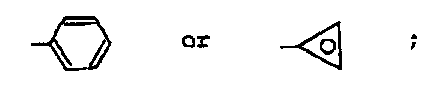 or
R₁ , R₂ and R₃ represent CH₃).

4. A radiation sensitive material according to claim 3 , wherein
vinylphenol of the resist containing hydrophilic groups is contained by 50 - 70 mol%.

5. A radiation sensitive material according to claim 2, wherein
the resist containing hydrophilic groups is a copolymer expressed by a general formula

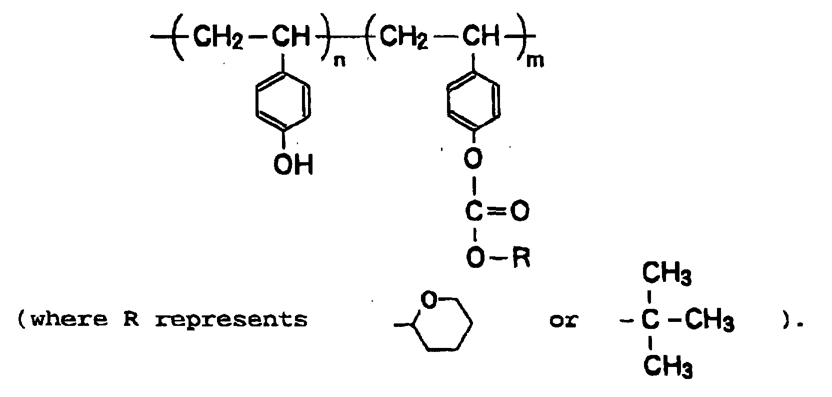

6. A radiation sensitive material according to claim 5, wherein vinylphenol in the resist containing the hydrophilic group is contained 60 - 80 mol%.

7. A radiation sensitive material according to any one of claims 2 to 6, wherein
the hydrophobic compound is expressed by

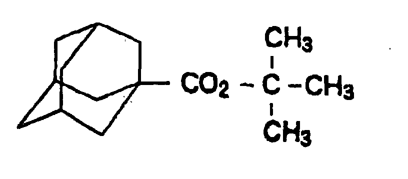

8. A radiation sensitive material according to any one of claims 2 to 6, wherein
the hydrophobic compound is expressed by a general formula 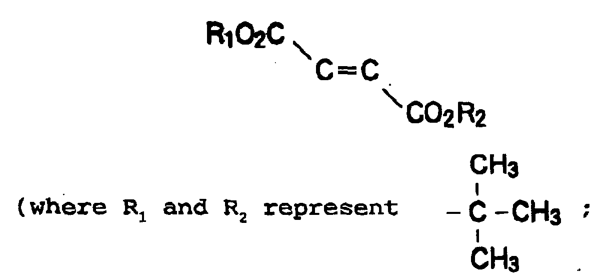 or
R₁ represents 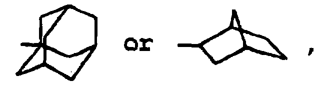 R₂ represents

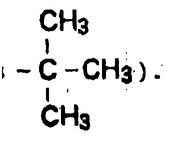

9. A radiation sensitive material comprising polymer units derived from itaconic anhydride and expressed by 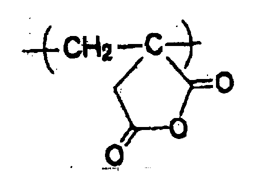 and polymer units which generate alkali soluble groups in the presence of an acid; and
a substance generating an acid by application of radiation.

10. A radiation sensitive material according to claim 9, wherein
the copolymer is expressed by a general formula 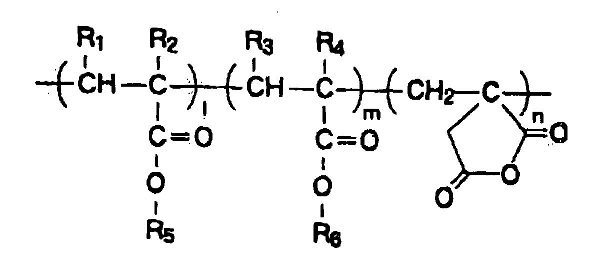 (where l, m and n represent 0 - 60 mol%, 10 - 95 mol%, 5 - 50 mol% respectively; R₁, R₂, R₃ and R₄ represent H, halogen, C₁₋₄ alkyl group, C₁₋₄ substituted alkyl group, nitrile group, -(CH₂)ₙCOOR₅(n=0-1) or -(CH₂)ₙCOOR₆(n=0-1); R₅ represents C₁₋₅ alkyl group, C₁₋₅ substituted alkyl group, alicyclic group, substituted alicyclic group, aromatic group or substituted aromatic group; and R₆ represents t-butyl group, t-amyl group, dimethylbenzyl group, tetrahydropyranyl group or 3-oxocyclohexyl group).

11. A radiation sensitive material according to claim 9, wherein
the copolymer is expressed by 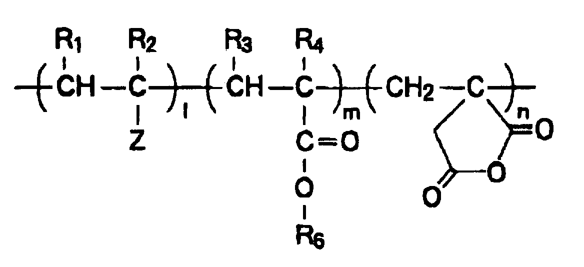 (where l, m and n represent 1 - 95 mol%, 10 - 95 mol% and 5 - 50 mol%; Z represents benzene ring, substituted benzene ring, nitrile group, -OR₇, -COR₇ or -OCOR₇; R₁, R₂, R₃ and R₄ represent H, halogen, C₁₋₄ alkyl group, C₁₋₄ substituted alkyl group, nitrile group, -C(CH₂)ₙCOOR₅(n=0-1), or - (CH₂)ₙCOOR₆(n=0-1); R₆ represents t-butyl group, t-amyl group, dimethylbenzyl group, tetrahydropyranyl group or 3-oxocyclohexyl group; R₇ represents C₁₋₅ alkyl group, C₁₋₅ substituted alkyl group, alicyclic group, substituted alicyclic group, aromatic group or substituted aromatic group).

12. A radiation sensitive material according to claim 9, wherein
the copolymer is expressed by a general formula 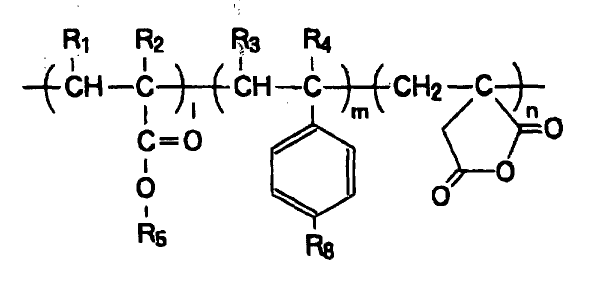 (where l, m and n represent 0 - 95 mol%, 1 - 95 mol% and 5 - 50 mol%; R₁, R₂, R₃ and R₄ represent H, halogen, C₁₋₄ alkyl group, C₁₋₄ substituted alkyl group, nitrile group, -(CH₂)ₙCOOR₅(n=0-1) or -(CH₂)ₙCOOR₆(n=0-1); R₅ represents C₁₋₅ alkyl group, C₁₋₅ substituted alkyl group, alicyclic group, substituted alicyclic group, aromatic group or substituted aromatic group; and R₈ represents -OtBu, -OCOOtBu or -COOt-Amyl).

13. A radiation sensitive material according to claim 9, wherein
the copolymer is expressed by a general formula 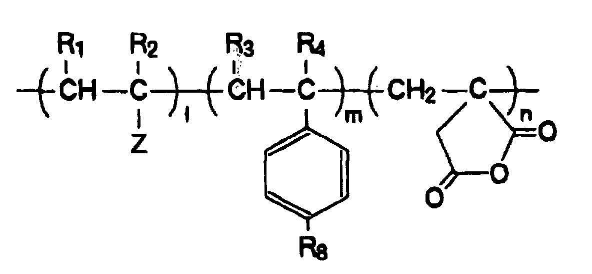 (where l, m and n represent 0 - 95 mol%, 1 - 95 mol% and 5 - 50 mol%; Z represents benzene ring, substituted benzene ring, nitrile group, OR₇, -COR₇ or -OCOR₇; R₁, R₂, R₃ and R₄ represent H, halogen, C₁₋₄ alkyl group, C₁₋₄ substituted alkyl group, nitrile group, -(CH₂)ₙCOOR₅(n=0-1) or -(CH₂)ₙCOOR₆(n=0-1); and R₈ represents -OtBu, -OCOOtBu, or -COOt-Amyl).

14. A radiation sensitive material according to any one of claims 9 to 13, wherein
the copolymer includes the unit structure including the itaconic anhydride by 5 - 50 mol%.

15. A method for forming a pattern comprising the steps of:
preparing a resist of a radiation sensitive material according to any preceding claim;
applying the resist to a substrate to be processed;
prebaking the substrate and then selectively exposing the resist on the substrate to radiation; and
postbaking the substrate, and then developing the resist on the substrate to form the pattern.

16. A method for forming a pattern comprising the steps of:
preparing a resist of a radiation sensitive material;
applying the resist to a substrate to be processed;
prebaking the substrate and then selectively exposing the resist on the substrate to radiation; and
postbaking the substrate, and than developing the resist on the substrate by a developer being a mixed liquid of an organic alkaline aqueous solution and isopropyl alcohol to form the pattern.

17. A method for forming a pattern according to claim 16, wherein the developer contains the isopropyl alcohol by 5 - 95 vol%.

18. A method for forming a pattern comprising the steps of:
preparing a resist of a polymer containing an acrylic ester unit, having an alicyclic group at an ester unit, or a methacrylic ester unit, having an alicyclic group at an ester unit, and an acrylic ester unit having a polar structure at an ester unit or a methacrylic ester unit having a polar structure at an ester unit;
coating a substrate to be processed with the resist, and prebaking the substrate to be processed;
applying onto the resist a protecting film of a hydrocarbon-based polymer, which is transparent to far ultraviolet rays, and heating the same;
selectively exposing radiation to the resist on the substrate to be processed;
postbaking the substrate to be processed; stripping the protecting film; and
developing the resist on the substrate to be processed to form a desired resist pattern,
an application solvent for the hydrocarbon-based polymer of the protecting film being a non-aromatic hydrocarbon, or an aromatic hydrocarbon expressed by a general formula 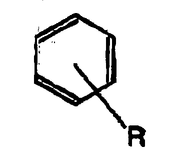 (where R represents an alkyl group with 3 or more carbon atoms).

19. A method for forming a pattern comprising the steps of:
forming a resist of a radiation sensitive material according to any one of claims 8 to 14;
coating a substrate-to-be-processed with the resist, and prebaking the substrate to be processed;
applying a protecting film of a hydrocarbon polymer, which is transparent to far ultraviolet rays, and heating the same;
selectively exposing radiation to the resist on the substrate to be processed, and postbaking the substrate to be processed; and
stripping the protecting film, and developing the resist on the substrate to be processed to form a desired resist pattern.

20. A method for forming a pattern according to claim 18 or 19, wherein an application solvent for the hydrocarbon polymer for the protecting film is limonene. 1,5-cycloctadiene, 1-decene, t-butylcyclohexane, p-cymene or dodecylbenzene.

21. A method for forming a pattern according to any one of claims 18, to 20, wherein
the hydrocarbon polymer is an olefine polymer or a diene polymer.

22. A method for forming a pattern according to claim 19 or either of claims 20 and 21 when appended to claim 19, wherein
the substance having a polar-structure is ketone, alcohol, ether, ester, carbonic acid, an acid anhydride, or any one of these substances having a part of the atoms of a polar structure.

23. A semiconductor fabrication method comprising a step of patterning the resist by a method for forming a pattern according to any one of claims 15 to 22.
